# EUROPEAN PATENT APPLICATION

(11) **EP 4 535 657 A1**
(43) Date of publication of application: **09.04.2025**
(21) Application number: 22953444.1
(22) Date of filing: 01.08.2022
(51) Int. Cl.: H03F 1/02, H03F 1/32, H04B 1/401

(54) **POWER AMPLIFICATION DEVICE, RADIO REMOTE UNIT, BASE STATION, AND COMMUNICATION SYSTEM**

(71) Applicant: Huawei Technologies Co., Ltd., Shenzhen, Guangdong 518129 (CN)
(72) Inventor: WANG, Lu, Shenzhen, Guangdong 518129 (CN); SUN, Jie, Shenzhen, Guangdong 518129 (CN); ZENG, Zhixiong, Shenzhen, Guangdong 518129 (CN)
(74) Representative: MERH-IP Matias Erny Reichl Hoffmann Patentanwälte PartG mbB
(86) International application number: PCT/CN2022/109493
(87) International publication number: WO 2024/026629

(57) **Abstract**

A power amplifier apparatus, a remote radio unit, a base station, and a communication system are provided, and relate to the field of communication technologies, to reduce energy consumption of the power amplifier apparatus. The power amplifier apparatus in this application includes a first power amplifier unit and a second power amplifier unit. An output port of the first power amplifier unit is connected to a first port of a circulator unit. An output port of the second power amplifier unit in M power amplifier units is connected to a second port of the circulator unit. The circulator unit is configured to output, through the second port and a third port, a signal received through the first port, and output, through the third port, a signal received through the second port. Because the circulator unit has a unidirectional transmission characteristic, the circulator unit may transmit, to the second port, the signal received through the first port, and then may modulate load impedance of the second power amplifier unit, to improve efficiency of the power amplifier apparatus at high back-off power, and reduce energy consumption of the power amplifier apparatus.

## Description

### TECHNICAL FIELD

This application relates to the field of communication technologies, and in particular, to a power amplifier apparatus, a remote radio unit, a base station, and a communication system.

### BACKGROUND

A power amplifier (Power Amplifier, PA) is an important component in a wireless communication base station. The power amplifier may be referred to as a power amplifier for short. Efficiency of the power amplifier determines power consumption, a size, a thermal design, and the like of the base station. Currently, to improve spectrum utilization efficiency, modulation signals with a plurality of different standards are used in wireless communication, for example, orthogonal frequency division multiplexing (orthogonal frequency division multiplexing, OFMA), code division multiple access (code division multiple access, CDMA), and time division multiple access (time division multiple access, TDMA). According to a specification in a related protocol, the signals with these standards have different peak-to-average power ratios (peak-to-average power ratios, PAPRs). For example, a peak-to-average power ratio of an OFDM signal is 10 dB to 12 dB.

Signals with high peak-to-average power ratios have higher requirements on the power amplifier in the base station. To amplify the signals with high peak-to-average power ratios without distortion, the power amplifier usually uses a power back-off method. To be specific, the power amplifier works in a class A state or class AB state, and enters a linear working region away from a saturation region, to improve linearity of the power amplifier. However, based on a characteristic of a power transistor, the method causes a significant decrease in the efficiency of the power amplifier, and increases the energy consumption of the base station under same output power.

### SUMMARY

This application provides a power amplifier apparatus, a remote radio unit, a base station, and a communication system, to reduce energy consumption of the power amplifier apparatus, thereby reducing power consumption of the base station.

**According to a first aspect,** this application provides a power amplifier apparatus. The apparatus includes M power amplifier units and a circulator unit connected to the M power amplifier units. M is an integer greater than 1. The M power amplifier units include a first power amplifier unit and a second power amplifier unit.

An output port of the first power amplifier unit is connected to a first port of the circulator unit. An output port of the second power amplifier unit is connected to a second port of the circulator unit. The circulator unit further includes a third port and a fourth port, and the fourth port is selectively connected to a load or a third power amplifier unit by using a first switch. When the fourth port is connected to the load by using the first switch, the circulator unit is configured to output, through the second port and the third port, a signal received through the first port, and output, through the third port, a signal received through the second port. When the fourth port is connected to the third power amplifier unit by using the first switch, the circulator unit is configured to output, through the fourth port to the third power amplifier unit, a signal received through the third port.

In this application, the first power amplifier unit is configured to amplify a received signal, and input an amplified signal into the first port. The second power amplifier unit is configured to amplify a received signal, and input an amplified signal into the second port. Because the circulator unit has a unidirectional transmission characteristic, the circulator unit may transmit, to the second port, the signal received through the first port, and then may modulate load impedance of the second power amplifier unit. Therefore, the power amplifier apparatus may improve efficiency of the power amplifier apparatus at high back-off power according to an active load modulation principle, to reduce energy consumption of the power amplifier apparatus, and further reduce power consumption of a base station configured with the power amplifier apparatus.

When a communication system in which the power amplifier apparatus is installed works in a time division duplex (time division duplex, TDD) mode, the first power amplifier unit and the second power amplifier unit may be components of a radio frequency transmit channel, and the third power amplifier unit may be a component of a radio frequency receive channel. Switching between the radio frequency transmit channel and the radio frequency receive channel may be implemented by using the first switch. In comparison with a solution in which a power amplifier is connected to an external circulator (for example, a main power amplifier and an auxiliary power amplifier of the power amplifier are connected to a combiner, the combiner is connected to a circulator, and the circulator implements switching between a transmit link and a receive link), in this application, the power amplifier apparatus may implement combination and switching between a transmit link and a receive link by using the circulator unit. In other words, the power amplifier apparatus does not need to be connected to an external circulator for implementing the switching between the transmit link and the receive link, so that an insertion loss of the transmit link in the communication system can be reduced.

In a possible implementation, the third port of the circulator unit is connected to an antenna. In this case, the circulator unit may transmit a signal of a radio frequency transmit channel via the antenna connected to the third port, to implement an air interface connection between a communication apparatus configured with the power amplifier apparatus and a terminal device.

In this application, because a characteristic of the circulator unit is that a signal entering any port of the circulator unit is sequentially transmitted to a next port or a plurality of ports in a direction determined by a static bias magnetic field, and the signal received by the circulator unit through the first port may be transmitted to the second port and the third port (for example, the signal received by the circulator unit through the first port may be sequentially transmitted to the second port and the third port), the first power amplifier unit may be considered to be in an isolated state relative to the second power amplifier unit. In other words, impedance of a port on a side of the first power amplifier unit may be close to a constant value, and an LPR of the first power amplifier unit may be close to 1, that is, there is no load pulling. A load-pull ratio closer to 1 indicates a better wideband characteristic of a matching network of a power amplifier unit. Therefore, a wideband characteristic of a matching network of the first power amplifier unit is good.

In a possible implementation, the first power amplifier unit is a main power amplifier unit, and the second power amplifier unit is an auxiliary power amplifier unit; or the first power amplifier unit is an auxiliary power amplifier unit, and the second power amplifier unit is a main power amplifier unit. When the first power amplifier unit is a main power amplifier unit, smaller power of a power transistor selected by the first power amplifier unit indicates a larger power back-off amount that can be implemented by the power amplifier apparatus. However, smaller power of a power transistor selected by the main power amplifier unit indicates larger optimal impedance Ropt of the main power amplifier unit. In a conventional Doherty (Doherty, DHT) solution, characteristic impedance of an impedance transformation line in a matching network of a main power amplifier needs to reach the optimal impedance Ropt. Because larger characteristic impedance of the impedance transformation line indicates a narrower microstrip, if power of a power transistor in the main power amplifier is set to a small value in the DHT solution, a physical implementation based on a distributed microstrip structure is difficult.

However, in this application, the circulator unit is disposed in the power amplifier apparatus, and impedance of a port of the circulator unit is usually a small value, for example, may be usually 50 ohms (ohms). In this case, characteristic impedance of a quarter-wave impedance transformation line of a matching network of the main power amplifier may be obtained through calculation by using Zt=sqrt (the optimal impedance Ropt*50). It can be learned that the characteristic impedance of the quarter-wave impedance transformation line of the matching network of the main power amplifier unit is less than the optimal impedance Ropt. Therefore, in comparison with the conventional DHT solution, in this application, the quarter-wave impedance transformation line of the matching network of the main power amplifier unit is physically easier to be implemented.

**In** a possible implementation, the power amplifier apparatus further includes a first signal decomposition module. An output port of the first signal decomposition module is separately connected to an input port of the first power amplifier unit and an input port of the second power amplifier unit. The first signal decomposition module is configured to obtain at least two paths of signals based on a received radio frequency signal, and respectively input the signals in the at least two paths of signals into the first power amplifier unit and the second power amplifier unit. The first signal decomposition module is configured to control amplitudes and/or phases of the two paths of signals input into the first power amplifier unit and the second power amplifier unit. For example, the first signal decomposition module may perform digital amplitude modulation and phase modulation or analog amplitude modulation and phase modulation on the two paths of signals input into the first power amplifier unit and the second power amplifier unit. In this case, the amplitudes and/or the phases of the two paths of signals of the first power amplifier unit and the second power amplifier unit may be controlled to alleviate an "efficiency dip" problem.

In a possible implementation, the first power amplifier unit is a main power amplifier unit, and the second power amplifier unit is an auxiliary power amplifier unit. The first signal decomposition module is specifically configured to: after the second power amplifier unit is enabled, control a value of a current of the signal input into the second power amplifier unit to increase as output power of the power amplifier apparatus increases, and control a value of a current of the signal input into the first power amplifier unit to decrease as the output power of the power amplifier apparatus increases; and when the value of the current of the signal input into the first power amplifier unit is less than a preset first current value, control a phase of the current of the signal input into the first power amplifier unit to rotate by 180 degrees, and control the value of the current of the signal input into the first power amplifier unit to increase as the output power of the power amplifier apparatus increases. In this case, an additional efficiency peak point may be generated in a medium-power region of the power amplifier apparatus, to alleviate an "efficiency dip" problem, and improve overall performance of the power amplifier apparatus.

In a possible implementation, the first power amplifier unit includes N1 power amplifier subunits and a first combiner. N1 is an integer greater than 1. Output ports of the N1 power amplifier subunits are connected to an input port of the first combiner, and an output port of the first combiner is connected to the first port of the circulator unit. Each of the N1 power amplifier subunits may be configured to amplify a received signal, and input an amplified signal into the first combiner. The first combiner is configured to input the signal received from the power amplifier subunit in the N1 power amplifier subunits into the first port. Because the first power amplifier unit includes a plurality of power amplifier subunits, an additional efficiency peak point may be generated in a medium-power region, to alleviate an "efficiency dip" problem.

In a possible implementation, the second power amplifier unit includes N2 power amplifier subunits and a second combiner. N2 is an integer greater than 1. Output ports of the N2 power amplifier subunits are connected to an input port of the second combiner, and an output port of the second combiner is connected to the second port of the circulator unit. Each of the N2 power amplifier subunits is configured to amplify a received signal, and input an amplified signal into the second combiner. The second combiner is configured to input the signal received from the power amplifier subunit in the N2 power amplifier subunits into the second port. Because the second power amplifier unit includes a plurality of power amplifier subunits, an additional efficiency peak point may be generated in a medium-power region, to alleviate an "efficiency dip" problem.

In a possible implementation, a power ratio of the first power amplifier unit and the N2 power amplifier subunits is determined based on a back-off amount corresponding to a set efficiency peak point of the power amplifier apparatus. In this case, a user may set the power ratio of the first power amplifier unit and the N2 power amplifier subunits based on a back-off amount corresponding to an actually required efficiency peak point, to satisfy diversified requirements of the user.

In a possible implementation, N2 is 2. The second power amplifier unit 3 may also be considered as using a DHT architecture. Therefore, the solution can be more compatible with the conventional technology.

In a possible implementation, M is an integer greater than 2. The circulator unit further includes (M-2) ports connected to (M-2) power amplifier units other than the first power amplifier unit and the second power amplifier unit in the M power amplifier units. When the fourth port is connected to the load by using the first switch, the circulator unit is further configured to output, through the third port, a signal received through the (M-2) ports. Because the power amplifier apparatus may include a large quantity of power amplifier units, a large quantity of efficiency peak points may be generated. Therefore, an "efficiency dip" problem may be alleviated, and overall performance of the power amplifier apparatus 1 may be improved.

In a possible implementation, the circulator unit may include one circulator or a plurality of circulators. For example, the circulator unit includes a first circulator, and the first circulator includes M ports connected to the M power amplifier units, the third port, and the fourth port. For another example, the circulator unit includes a first circulator and a second circulator, and the first circulator is connected to the second circulator. M ports connected to the M power amplifier units, the third port, and the fourth port are deployed in the first circulator and the second circulator. In this case, solution flexibility can be improved.

**According to a second aspect,** an embodiment of this application provides a power amplifier apparatus, including M power amplifier units and a circulator unit connected to the M power amplifier units. M is an integer greater than 1. The M power amplifier units include a first power amplifier unit and a second power amplifier unit. An output port of the first power amplifier unit is selectively connected to a first port of the circulator unit or an input port of the second power amplifier unit by using a second switch. An output port of the second power amplifier unit is connected to a second port of the circulator unit. The circulator unit further includes a third port. The circulator unit is configured to: when a signal is received through the first port, output, through the second port and the third port, the signal received through the first port; and when a signal is received through the second port, output, through the third port, the signal received through the second port.

Because the second switch is added between the first power amplifier unit and the second power amplifier unit, when the first power amplifier unit is connected to the second power amplifier unit by using the second switch, a signal may be amplified by the first power amplifier unit and then enter the second power amplifier unit, so that the second power amplifier unit further amplifies the signal. Because the signal may be amplified by the first power amplifier unit and the second power amplifier unit, a back-off amount of the power amplifier apparatus may be increased, and back-off efficiency is improved.

In a possible implementation, the circulator unit further includes a fourth port, and the fourth port is selectively connected to a load or a third power amplifier unit by using a first switch. When the fourth port is connected to the load by using the first switch, the circulator unit is configured to: when a signal is received through the first port, output, through the second port and the third port, the signal received through the first port; and when a signal is received through the second port, output, through the third port, the signal received through the second port. When the fourth port is connected to the third power amplifier unit by using the first switch, the circulator unit is configured to output, to the third power amplifier unit through the fourth port, a signal received through the third port.

When a communication system in which the power amplifier apparatus is installed works in a TDD mode, the first power amplifier unit and the second power amplifier unit may be components of a radio frequency transmit channel, and the third power amplifier unit may be a component of a radio frequency receive channel. Switching between the radio frequency transmit channel and the radio frequency receive channel may be implemented by using the first switch. In comparison with a solution in which a power amplifier is connected to an external circulator (for example, a main power amplifier and an auxiliary power amplifier of the power amplifier are connected to a combiner, the combiner is connected to a circulator, and the circulator implements switching between a transmit link and a receive link), in this application, the power amplifier apparatus may implement combination and switching between a transmit link and a receive link by using the circulator unit. In other words, the power amplifier apparatus does not need to be connected to an external circulator for implementing the switching between the transmit link and the receive link, so that an insertion loss of the transmit link in the communication system can be reduced.

In a possible implementation, the power amplifier apparatus further includes a control unit. The control unit is connected to the second switch. The control unit is configured to: when power of the power amplifier apparatus is less than a first power value, control the output port of the first power amplifier unit to be connected to the first port by using the second switch.

In a possible implementation, the control unit is further configured to: when the power of the power amplifier apparatus is not less than the first power value, control the output port of the first power amplifier unit to be connected to the input port of the second power amplifier unit by using the second switch.

When the power amplifier apparatus works at low power, the second switch is switched to the first port, and the second power amplifier unit is in a disabled state. In this case, a radio frequency signal is directly amplified under drive of the first power amplifier unit, enters the circulator unit, and is output through the third port. When the power amplifier apparatus works at high power, the second switch is switched from the first port to the second power amplifier unit. In this case, a radio frequency signal is directly amplified under drive of the first power amplifier unit, is further amplified by the second power amplifier unit, enters the circulator unit, and is output through the third port, so that a back-off amount of the power amplifier apparatus can be increased, and back-off efficiency is improved.

In a possible implementation, the power amplifier apparatus further includes a second signal decomposition module. An output port of the second signal decomposition module is connected to an input port of the first power amplifier unit. The second signal decomposition module is configured to divide a received radio frequency signal into K1 channels of signals, and input the signals in the K1 channels of signals into input ports of K1 power amplifier subunits of the first power amplifier unit. K1 is an integer greater than 1.

Because of a high-efficiency power amplifier architecture nested in the first power amplifier unit, a back-off amount of the power amplifier apparatus may be further increased, back-off efficiency may also be improved, and a large quantity of peak points may be added in a medium-power region, so that an "efficiency dip" problem can be alleviated.

In a possible implementation, the power amplifier apparatus further includes a third signal decomposition module. The output port of the first power amplifier unit is selectively connected to the first port or an input port of the third signal decomposition module by using the second switch. An output port of the third signal decomposition module is connected to the input port of the second power amplifier unit.

In a possible implementation, M is an integer greater than 2. The output port of the third signal decomposition module is further connected to input ports of (M-1) power amplifier units other than the first power amplifier unit in the M power amplifier units. The circulator unit further includes (M-1) ports connected to the (M-1) power amplifier units other than the first power amplifier unit in the M power amplifier units. Output ports of the (M-1) power amplifier units are connected to the (M-1) ports of the circulator unit in one-to-one correspondence. For example, an output port of one of the (M-1) power amplifier units is connected to one of the (M-1) ports of the circulator unit, and one of the (M-1) ports of the circulator unit is connected to an output port of one of the (M-1) power amplifier units.

Because the power amplifier apparatus may include a large quantity of power amplifier units, and a signal amplified by the first power amplifier unit may be amplified again by using a plurality of power amplifier units, a back-off amount of the power amplifier apparatus may be further increased, back-off efficiency may also be improved, and a large quantity of peak points are added in a medium-power region, so that an "efficiency dip" problem can be alleviated.

In a possible implementation, the third signal decomposition module is configured to divide a received radio frequency signal into K2 channels of signals, and input the signals in the K2 channels of signals into input ports of K2 power amplifier subunits of the second power amplifier unit. K2 is an integer greater than 1. Because of a high-efficiency power amplifier architecture nested in the second power amplifier unit, a back-off amount of the power amplifier apparatus may be further increased, back-off efficiency may also be improved, and a large quantity of peak points may be added in a medium-power region, so that an "efficiency dip" problem can be alleviated.

In a possible implementation, the circulator unit is further configured to output, through the third port, a signal received through (M-2) ports.

In a possible implementation, the third port of the circulator unit is connected to an antenna. In this case, the circulator unit may transmit a signal of a radio frequency transmit channel via the antenna connected to the third port, to implement an air interface connection between a communication apparatus configured with the power amplifier apparatus and a terminal device.

In a possible implementation, the circulator unit may include one circulator or a plurality of circulators. For example, the circulator unit includes a first circulator, and the first circulator includes M ports connected to the M power amplifier units, the third port, and the fourth port. For another example, the circulator unit includes a first circulator and a second circulator, and the first circulator is connected to the second circulator. M ports connected to the M power amplifier units, the third port, and the fourth port are deployed in the first circulator and the second circulator. In this case, solution flexibility can be improved.

In a possible implementation, the first power amplifier unit is a main power amplifier unit or an auxiliary power amplifier unit, and the second power amplifier unit is of a power amplifier type different from that of the first power amplifier unit in the main power amplifier unit and the auxiliary power amplifier unit. In this case, solution flexibility can be improved.

**According to a third aspect,** an embodiment of this application provides a remote radio unit, including the power amplifier apparatus according to any one of the first aspect and the possible implementations of the first aspect.

**According to a fourth aspect,** an embodiment of this application provides a remote radio unit, including the power amplifier apparatus according to any one of the second aspect and the possible implementations of the second aspect.

**According to a fifth aspect,** an embodiment of this application provides a base station, including the remote radio unit according to the third aspect or the fourth aspect.

**According to a sixth aspect,** an embodiment of this application provides a communication system, including a baseband processing unit, at least one power amplifier apparatus according to any one of the first aspect and the possible implementations of the first aspect that is connected to the baseband processing unit, and an antenna connected to the third port of the circulator unit in the power amplifier apparatus.

**According to a seventh aspect,** an embodiment of this application provides a communication system, including a baseband processing unit, at least one power amplifier apparatus according to any one of the second aspect and the possible implementations of the second aspect that is connected to the baseband processing unit, and an antenna connected to the third port of the circulator unit in the power amplifier apparatus.

### BRIEF DESCRIPTION OF DRAWINGS

FIG. 1 is a diagram of a scenario to which an embodiment of this application is applicable;
FIG. 2A and FIG. 2B are diagrams of structures of several communication systems according to embodiments of this application;
FIG. 3A, FIG. 3B, and FIG. 3C are diagrams of several possible structures of a power amplifier apparatus 1 according to embodiments of this application;
FIG. 4A and FIG. 4B are diagrams of several possible efficiency curves of a power amplifier apparatus 1;
FIG. 5A is a diagram of another possible structure of a communication system according to an embodiment of this application;
FIG. 5B is a curve diagram of voltages of a first power amplifier unit and the second power amplifier unit in FIG. 5A and normalized output power Pout;
FIG. 5C is a curve diagram of currents of a first power amplifier unit and a second power amplifier unit in FIG. 5A and normalized output power Pout;
FIG. 5D is a curve diagram of efficiency of a first power amplifier unit and a second power amplifier unit in FIG. 5 A and normalized output power Pout;
FIG. 6A is a diagram of another possible structure of a communication system according to an embodiment of this application;
FIG. 6B is a diagram of a possible efficiency curve of a power amplifier apparatus 1 when a first power amplifier unit 2 in FIG. 6A is a main power amplifier unit;
FIG. 6C is a diagram of a possible efficiency curve of a power amplifier apparatus 1 when a PA 31 in a second power amplifier unit 3 in FIG. 6A is a main power amplifier unit;
FIG. 7A, FIG. 7B, and FIG. 7C are diagrams of several possible structures of a power amplifier unit 10 in M power amplifier units according to embodiments of this application;
FIG. 7D is a diagram of an architecture of another possible communication system to which an embodiment of this application is applicable;
FIG. 8A, FIG. 8B, and FIG. 8C are diagrams of several possible structures of a circulator unit 4 according to embodiments of this application;
FIG. 9A, FIG. 9B, and FIG. 9C are diagrams of architectures of several communication systems to which embodiments of this application are applicable;
FIG. 10 is a diagram of a possible structure of another power amplifier apparatus 1 according to an embodiment of this application;
FIG. 11 is a diagram of a possible structure of another power amplifier apparatus 1 according to an embodiment of this application;
FIG. 12A is a diagram of a structure of another possible power amplifier apparatus 1 according to an embodiment of this application;
FIG. 12B is a diagram of a possible efficiency curve of the power amplifier apparatus 1 in FIG. 12A;
FIG. 13 is a diagram of a structure of another possible power amplifier apparatus 1 according to an embodiment of this application; and
FIG. 14A and FIG. 14B are diagrams of several other possible structures of a power amplifier apparatus 1 according to embodiments of this application.

### DESCRIPTION OF EMBODIMENTS

Technical solutions in embodiments of this application may be applied to various communication systems, for example, a long term evolution (Long Term Evolution, LTE) system, an LTE frequency division duplex (Frequency Division Duplex, FDD) system, an LTE time division duplex (Time Division Duplex, TDD) system, a 5th generation (5th Generation, 5G) system, a new radio (New Radio, NR) system, and another future communication system. This is not limited herein.

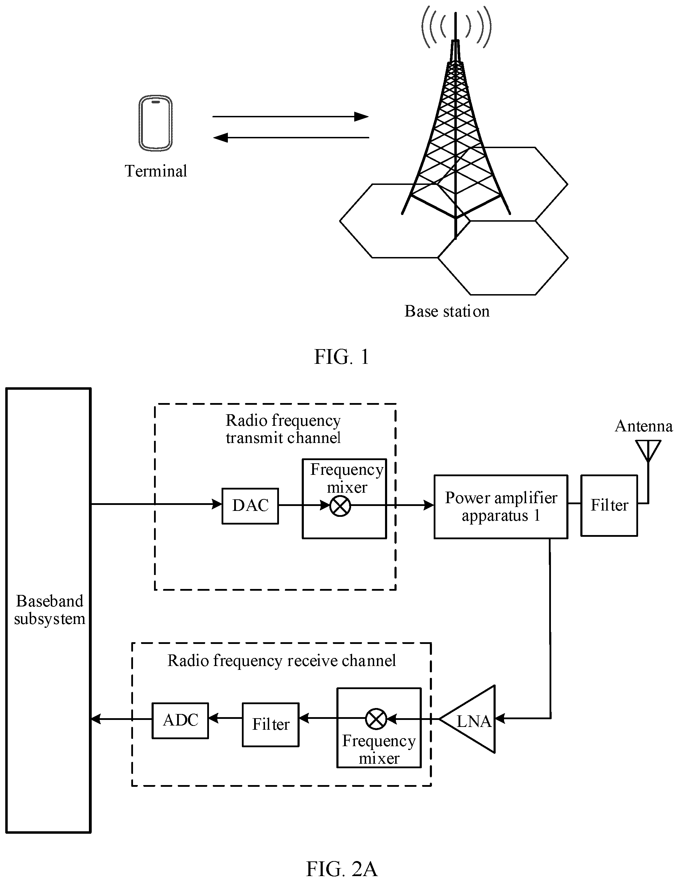

In a wireless communication system, devices may be classified into devices that provide a wireless network service and devices that use the wireless network service. FIG. 1 is an example diagram of a scenario to which an embodiment of this application is applicable. In FIG. 1, an example in which a device that provides a wireless network service is a base station, and a device that uses a wireless network service is a terminal is used for illustration.

The devices that provide the wireless network service are devices that are a part of a wireless communication network, and may be referred to as network devices (network devices) or network elements (network elements) for short. The network device generally belongs to an operator or an infrastructure provider, and is operated or maintained by these vendors. The network devices may be further classified into radio access network (radio access network, RAN) devices and core network (core network, CN) devices. A typical RAN device includes a base station (base station, BS).

It should be understood that the base station sometimes may be also referred to as a wireless access point (access point, AP) or a transmission reception point (transmission reception point, TRP). Specifically, the base station may be a generation NodeB (generation NodeB, gNB) in a 5G new radio (new radio, NR) system or an evolved NodeB (evolved NodeB, eNB) in a 4G long term evolution (long term evolution, LTE) system. Base stations may be classified into macro base stations (macro base stations) and micro base stations (micro base stations) based on different physical forms or transmit power of the base stations. The micro base station sometimes is also referred to as a small base station or a small cell (small cell).

The device that uses the wireless network service may be referred to as a terminal (terminal) for short. Still refer to FIG. 1. The terminal can establish a connection to the network device, and provide a specific wireless communication service for a user based on the service of the network device. It should be understood that, because the terminal has a closer relationship with the user, the terminal sometimes is also referred to as user equipment (user equipment, UE) or a subscriber unit (subscriber unit, SU). In addition, in comparison with a base station that is generally placed at a fixed location, the terminal usually moves along with the user, and sometimes is also referred to as a mobile station (mobile station, MS). In addition, some network devices such as relay nodes (relay nodes, RNs) or wireless routers sometimes may also be considered as terminals because the network devices have UE identities or belong to the user.

Specifically, the terminal may be a mobile phone (mobile phone), a tablet computer (tablet computer), a laptop computer (laptop computer), a wearable device (for example, a smart watch, a smart band, a smart helmet, or smart glasses), or another device that has a wireless access capability, for example, an intelligent vehicle or various internet of things (internet of things, IoT) devices including various smart home devices (such as a smart meter and a smart home appliance) and smart city devices (such as a security or monitoring device and an intelligent road transportation facility).

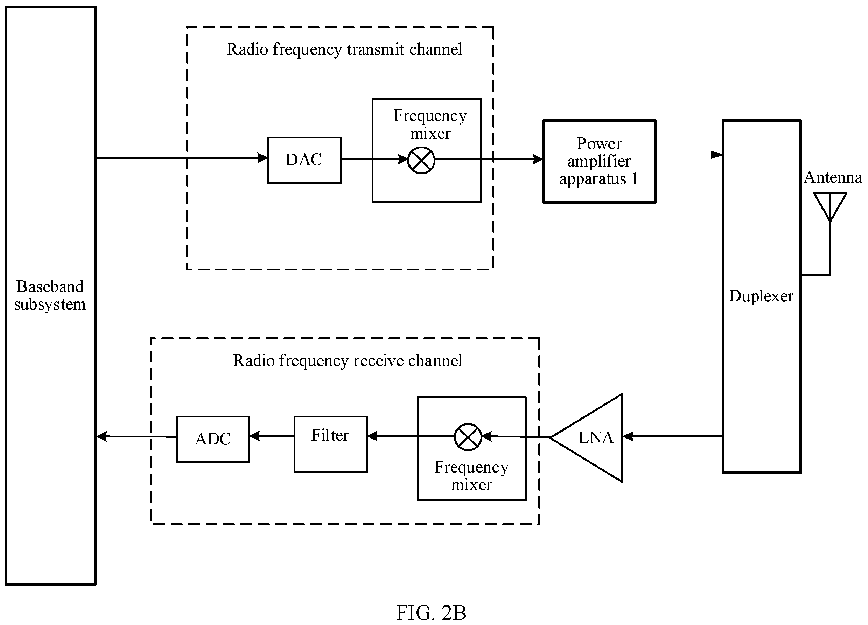

Based on content shown in FIG. 1, **FIG. 2A** **and** **FIG. 2B** **are example diagrams** of structures of several communication systems according to embodiments of this application. The structures of the communication systems shown in FIG. 2A **and** **FIG. 2B** may be deployed in the base station shown in FIG. 1.

FIG. 2A shows some common components for radio frequency signal processing in the communication system. The communication system includes a baseband subsystem. A to-be-sent signal generated by the baseband subsystem may be sent through a radio frequency transmit channel. The radio frequency transmit channel may include components such as a digital-to-analog converter (digital-to-analog converter, DAC) and a frequency mixer. Before an output signal of the radio frequency transmit channel is transmitted via an antenna, power amplification processing is further performed on the output signal of the radio frequency transmit channel by using a power amplifier apparatus 1, filtering processing may be further performed by using a filter, and then the output signal is transmitted via the antenna.

The power amplifier apparatus 1 in a system architecture shown in FIG. 2A may have a function of implementing switching between the radio frequency transmit channel and a radio frequency receive channel. For example, when the communication system works in a TDD mode, the power amplifier apparatus 1 has the function of implementing the switching between the radio frequency transmit channel and the radio frequency receive channel. A signal received by the base station via the antenna may be further transmitted to the radio frequency receive channel by using a component in the power amplifier apparatus 1. For example, the signal received by the base station via the antenna may be transmitted to a low noise amplifier (low noise amplifier, LNA) after being processed by the filter. The LNA amplifies the received signal and sends an amplified signal to the radio frequency receive channel. The radio frequency receive channel may include components such as a frequency mixer, a filter, and an analog-to-digital converter (analog-to-digital converter, ADC). The radio frequency receive channel transmits a processed signal to the baseband subsystem for processing.

FIG. 2 is merely an example. The components included in the radio frequency receive channel and the radio frequency transmit channel are not listed one by one in this embodiment of this application. It should be understood that although FIG. 2 shows only one radio frequency receive channel and one radio frequency transmit channel, the communication system in this embodiment of this application is not limited thereto. The communication system may include one or more radio frequency receive channels and one or more radio frequency transmit channels.

It should be noted that the communication system shown in FIG. 2A may be considered as an example of a possible application scenario of the power amplifier apparatus 1. During actual application, the power amplifier apparatus 1 may also be used in another scenario in which a signal needs to be amplified and a radio frequency receive channel and a radio frequency transmit channel need to be switched.

Refer to **FIG. 2B****.** In comparison with FIG. 2A, the communication system shown in FIG. 2B may further include a duplexer, and the communication system shown in FIG. 2B may work in an FDD mode. Before an output signal of a radio frequency transmit channel is transmitted via an antenna, power amplification processing is further performed on the output signal of the radio frequency transmit channel by using a power amplifier apparatus 1, and then the output signal is transmitted via the antenna. In FIG. 2B, the power amplifier apparatus 1 may not need to have a function of implementing switching between the radio frequency transmit channel and a radio frequency receive channel. Other content in FIG. 2B is similar to content in FIG. 2A, and details are not described again.

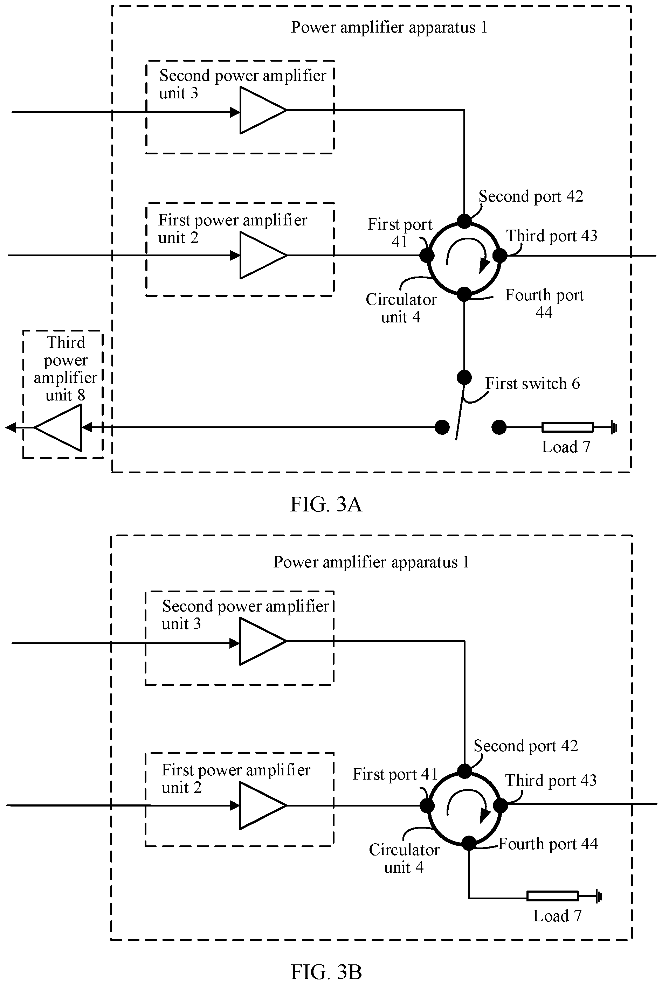

Based on embodiments shown in FIG. 1 and FIG. 2A, and the foregoing other content, **FIG. 3A** is an example diagram of a possible structure of a power amplifier apparatus 1 according to an embodiment of this application. The power amplifier apparatus 1 shown in FIG. 3A may be the power amplifier apparatus 1 shown in FIG. 2A.

As shown in FIG. 3A, the power amplifier apparatus 1 includes M power amplifier units and a circulator unit 4, and the M power amplifier units are connected to the circulator unit 4. M is an integer greater than 1, and M may be 2, or may be greater than 2. In FIG. 3A, an example in which the M power amplifier units include a first power amplifier unit 2 and a second power amplifier unit 3 is used for illustration. In this embodiment of this application, one of the M power amplifier units may include one power amplifier (in other words ,the power amplifier unit may also be referred to as a power amplifier unit implemented by a single power transistor), or one power amplifier unit may include a plurality of power amplifiers (in other words ,the power amplifier unit may also be referred to as a power amplifier unit implemented by a plurality of power transistors). The power amplifier unit in the M power amplifier units may amplify a received signal. In FIG. 3A, an example in which the first power amplifier unit includes one power amplifier, and the second power amplifier unit includes one power amplifier is used for illustration.

The circulator unit in this embodiment of this application may include one or more circulators. The circulator is a component in which an incident wave (a signal) entering any port of the circulator unit is sequentially transmitted to a next port or a plurality of ports in a direction determined by a static bias magnetic field. In FIG. 3A, an example in which the circulator unit 4 includes one circulator, and a transmission direction of a signal in the circulator is a clockwise direction is used for illustration. Four or more ports are provided on the circulator unit 4. In FIG. 3A, an example in which four ports are provided on the circulator unit 4 is used for description.

Refer to FIG. 3A. The circulator unit 4 includes a first port 41, a second port 42, a third port 43, and a fourth port 44. An output port of the first power amplifier unit 2 is connected to the first port 41. An output port of the second power amplifier unit 3 is connected to the second port 42. The fourth port 44 of the circulator unit 4 is selectively connected to a load 7 or a third power amplifier unit 8 by using a first switch 6.

The load 7 may be, for example, a resistor. Impedance of the resistor may be the same as or close to impedance of a port of the circulator. For example, if impedance of the fourth port is 50 ohms (ohms), the impedance of the load 7 may also be 50 ohms (ohms), so that the impedance of the load matches the impedance of the port of the circulator connected to the load. To understand a solution provided in this embodiment of this application more clearly, FIG. 3A also shows the third power amplifier unit 8. The third power amplifier unit 8 may be a power amplifier connected to a radio frequency receive channel. The third power amplifier unit 8 may include one or more power amplifiers. For example, the third power amplifier unit 8 may be the LNA in FIG. 2A.

As shown in FIG. 3A, the power amplifier apparatus may implement switching between a radio frequency transmit channel and the radio frequency receive channel by using the first switch 6.

### (1) The radio frequency transmit channel is in a working state.

When the radio frequency transmit channel needs to be in the working state (where in this case, the radio frequency receive channel may be in a non-working state, in other words, the radio frequency receive channel is not in the working state), the fourth port 44 may be connected to the load 7 by using the first switch 6. In this case, the circulator unit 4 may transmit, to the second port 42 and the third port 43, a signal received through the first port 41 (for example, the circulator unit 4 may sequentially transmit, to the second port 42 and the third port 43, a signal received through the first port 41), and output, through the third port 43, a signal received through the second port 42.

In a possible implementation, the third port 43 may be connected to another component (such as a filter). Impedance of the component connected to the third port 43 is set to a value that is the same as or close to impedance of the third port 43. In this case, the impedance of the component connected to the third port 43 is close to matching the impedance of the third port 43. Therefore, almost all of signals received through the first port 41 and the second port 42 can be transmitted outside through the third port 43.

Because the circulator unit 4 has a unidirectional transmission characteristic, the circulator unit 4 may transmit, to the second port 42, the signal received through the first port 41, and then may modulate load impedance of the second power amplifier unit 3. Therefore, the power amplifier apparatus 1 may improve efficiency of the power amplifier apparatus 1 at high back-off power according to an active load modulation principle, to reduce energy consumption of the power amplifier apparatus 1, and further reduce power consumption of a base station configured with the power amplifier apparatus 1.

Because the characteristic of the circulator unit 4 is that a signal entering any port of the circulator unit 4 is sequentially transmitted to a next port or a plurality of ports in the direction determined by the static bias magnetic field, and the signal received by the circulator unit 4 through the first port may be transmitted to the second port 42 and the third port 43 (for example, the signal received by the circulator unit 4 through the first port may be sequentially transmitted to the second port 42 and the third port 43), the first power amplifier unit may be considered to be in an isolated state relative to the second power amplifier unit. In other words, impedance of a port on a side of the first power amplifier unit may be close to a constant value, and a load-pull ratio (load-pull ratio, LPR) of the first power amplifier unit may be close to 1, that is, there is no load pulling. A load-pull ratio closer to 1 indicates a better wideband characteristic of a matching network of a power amplifier unit. Therefore, a wideband characteristic of a matching network of the first power amplifier unit 2 is good.

In a possible implementation, when the first power amplifier unit 2 is a main power amplifier unit, smaller power of a power transistor selected by the first power amplifier unit 2 indicates a larger power back-off amount that can be implemented by the power amplifier apparatus 1. However, smaller power of a power transistor selected by the main power amplifier unit indicates larger optimal impedance Ropt of the main power amplifier unit. In a conventional DHT solution, characteristic impedance of an impedance transformation line in a matching network of a main power amplifier needs to reach the optimal impedance Ropt. Because larger characteristic impedance of the impedance transformation line indicates a narrower microstrip, if power of a power transistor in the main power amplifier is set to a small value in the DHT solution, a physical implementation based on a distributed microstrip structure is difficult.

However, in this application, the circulator unit is disposed in the power amplifier apparatus, and impedance of a port of the circulator unit is usually a small value, for example, may be usually 50 ohms (ohms). In this case, characteristic impedance of a quarter-wave impedance transformation line of a matching network of the main power amplifier may be obtained through calculation by using Zt=sqrt (the optimal impedance Ropt*50). It can be learned that the characteristic impedance of the quarter-wave impedance transformation line of the matching network of the main power amplifier unit is less than the optimal impedance Ropt. Therefore, in comparison with the conventional DHT solution, in this application, the quarter-wave impedance transformation line of the matching network of the main power amplifier unit is physically easier to be implemented.

### (2) The radio frequency receive channel is in a working state.

When the radio frequency receive channel needs to be in the working state (where in this case, the radio frequency transmit channel may be in a non-working state, in other words, the radio frequency transmit channel is not in the working state), the fourth port 44 may be connected to the third power amplifier unit 8 by using the first switch 6. The third power amplifier unit 8 may be, for example, the LNA in FIG. 2A. In this case, the circulator unit 4 is configured to output, to the third power amplifier unit 8 through the fourth port 44, a signal received through the third port 43.

Because impedance of the third power amplifier unit 8 is set to a value that is the same as or close to impedance of the fourth port 44, the impedance of the third power amplifier unit 8 is close to matching the impedance of the fourth port 44. In addition, because the radio frequency transmit channel is in the non-working state, in other words, is not in the working state, that is, the M power amplifier units are in a disabled state, almost all of signals received through the third port 43 can be transmitted outside through the fourth port 44.

It can be further learned from the foregoing content that, the switching between the radio frequency transmit channel and the radio frequency receive channel may be implemented by using the first switch 6. In comparison with a solution in which a power amplifier is connected to an external circulator (for example, a main power amplifier and an auxiliary power amplifier of the power amplifier are connected to a combiner, the combiner is connected to the circulator, and the circulator implements switching between a transmit link and a receive link), in this application, the power amplifier apparatus 4 may implement combination and switching between a transmit link and a receive link by using the circulator unit 7. In other words, the power amplifier apparatus 4 does not need to be connected to an external circulator for implementing the switching between the transmit link and the receive link, so that an insertion loss of the transmit link in a communication system can be reduced.

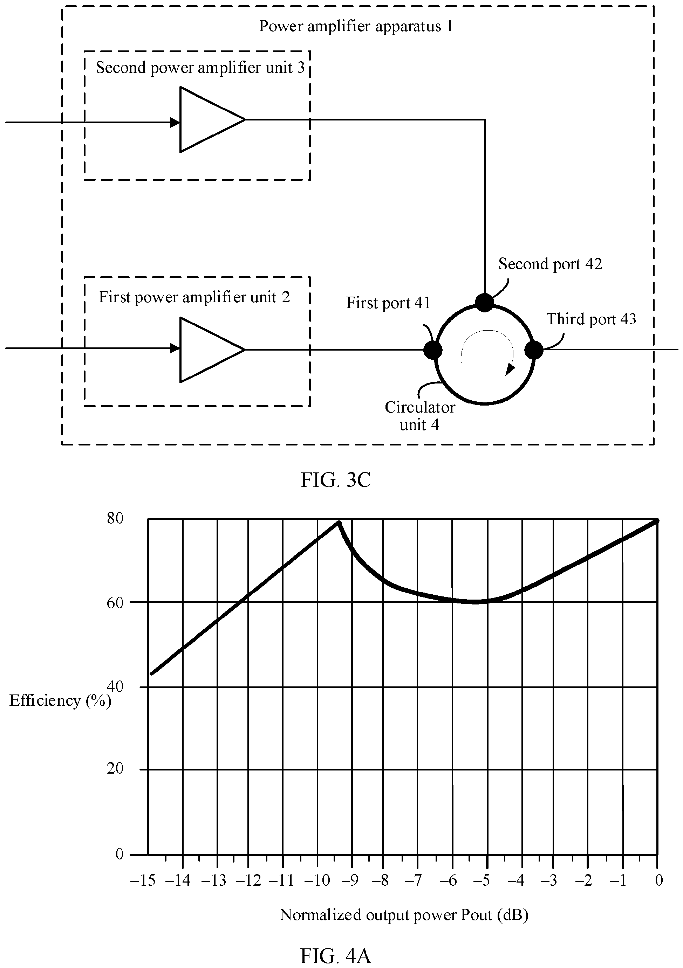

Based on embodiments shown in FIG. 1 and FIG. 2B, and the foregoing other content, FIG. **3B** **and** **FIG. 3C** are example diagrams of several other possible structures of a power amplifier apparatus 1 according to embodiments of this application.

The power amplifier apparatus 1 shown in FIG. 3B and FIG. 3C may be the power amplifier apparatus 1 shown in FIG. 2B. It can be learned from FIG. 2B that the power amplifier apparatus 1 provided in embodiments of this application may not need to have a function of implementing switching between a radio frequency transmit channel and a radio frequency receive channel. Therefore, in comparison with FIG. 3A, a fourth port 44 of a circulator unit 4 in FIG. 3B may be directly connected to a load 7, and a first switch 6 does not need to be disposed in the power amplifier apparatus 1. In comparison with FIG. 3A, a circulator unit 4 in FIG. 3C may not include a fourth port 44, and the power amplifier apparatus also does not need to include a first switch 6 or a load 7 connected to the fourth port 44.

Refer to FIG. 3B or FIG. 3C. The power amplifier apparatus 1 includes M power amplifier units and the circulator unit 4, and the M power amplifier units are connected to the circulator unit 4. The circulator unit 4 may be configured to transmit, to a second port 42 and a third port 43, a signal received through a first port 41, and output, through the third port 43, a signal received through the second port 42.

Because the circulator unit 4 has a unidirectional transmission characteristic, the circulator unit 4 may transmit, to the second port 42, the signal received through the first port 41, and then may modulate load impedance of a second power amplifier unit 3. Therefore, the power amplifier apparatus 1 may improve efficiency of the power amplifier apparatus 1 at high back-off power according to an active load modulation principle, to reduce energy consumption of the power amplifier apparatus 1, and further reduce power consumption of a base station configured with the power amplifier apparatus 1.

For related content in FIG. 3B and FIG. 3C, refer to related descriptions in FIG. 3A. Details are not described again.

In embodiments shown in FIG. 3A, FIG. 3B, and FIG. 3C, the first power amplifier unit 2 is a main power amplifier unit or an auxiliary power amplifier unit, and the second power amplifier unit 3 is of a power amplifier type different from that of the first power amplifier unit 2 in the main power amplifier unit and the auxiliary power amplifier unit. In a possible implementation, when power of an input signal of the power amplifier apparatus 1 is low, the main power amplifier unit may work, and the auxiliary power amplifier unit does not work. In addition, after the main power amplifier unit gradually reaches a saturation state, as input power of the power amplifier apparatus gradually increases, the auxiliary power amplifier unit is enabled, until both the main power amplifier unit and the auxiliary power amplifier unit reach the saturation state.

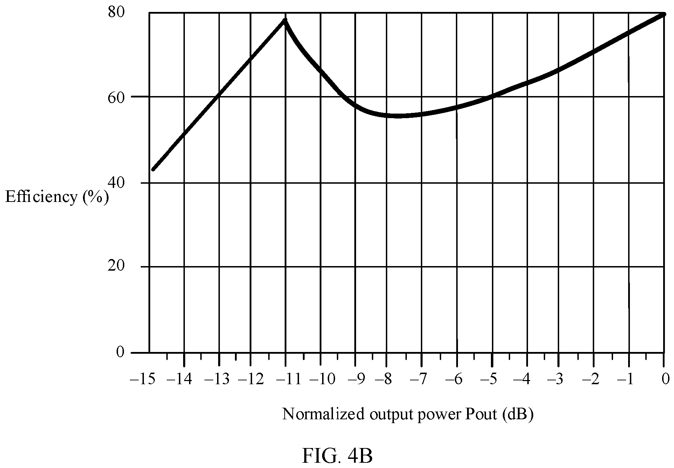

Based on embodiments shown in FIG. 1, FIG. 2A, FIG. 2B, FIG. 3A, FIG. 3B, and FIG. 3C, and the foregoing other content, **FIG. 4A** **and** **FIG. 4B** are example diagrams of several possible efficiency curves of a power amplifier apparatus 1.

**FIG. 4A** shows an example in which a first power amplifier unit 2 is a main power amplifier unit, a second power amplifier unit 3 is an auxiliary power amplifier unit, the first power amplifier unit includes one power amplifier, the second power amplifier unit includes one power amplifier, and a power ratio of maximum output power of the first power amplifier unit to maximum output power of the second power amplifier unit is 1:8.

Refer to FIG. 4A. Based on different power strength of an input signal, a working region of the power amplifier apparatus 1 may be roughly divided into three stages: a low-power region, a medium-power region, and a high-power region. The following describes the foregoing three stages in detail with reference to the diagram of the efficiency curve of the power amplifier apparatus 1 in FIG. 4A.

### (1) Low-power region (a region in which normalized output power of the power amplifier apparatus in FIG. 4A is less than -9.5 dB)

In the low-power region, a biasing mode of a path (Peak path) of the auxiliary power amplifier unit is a class C, and input power of the path is insufficient to drive the auxiliary power amplifier unit to work. In this case, the peak path is in an open-path state, or it may be understood as that the peak path is not enabled. In addition, a biasing mode of a path (Main path) of the main power amplifier unit may be a class AB, and impedance remains unchanged. As input power of the power amplifier apparatus 1 increases, the main power amplifier unit enters a saturation state, and a voltage reaches full swing, to achieve a first high-efficiency point in a working process of the power amplifier apparatus 1. As shown in FIG. 4A, a power back-off point corresponding to the first high-power point of the power amplifier apparatus 1 is -9.5 dB. In other words, the input power of the power amplifier apparatus 1 is 9.5 dB less than that when both the main power amplifier unit and the auxiliary power amplifier unit in the power amplifier apparatus 1 are at full power.

### (2) Medium-power region (a region in which normalized output power Pout of the power amplifier apparatus in FIG. 4A is between -9.5 dB and 0 dB)

As the input power of the power amplifier apparatus 1 gradually increases, the peak path is enabled. In this case, the impedance of the main path gradually decreases, but the voltage of the main path is always at full swing, and the main path remains in the saturation state. In addition, impedance of the peak path also gradually decreases, and a voltage gradually increases. Working efficiency and output power of the peak path increase as power of the input signal increases, but the peak path does not reach the saturation state. Therefore, total working efficiency of the power amplifier apparatus 1 first decreases and then increases.

In this embodiment of this application, each region may alternatively have another name. For example, the medium-power region may also be referred to as a back-off region.

### (3) High-power region (a region in which normalized output power Pout of the power amplifier apparatus in FIG. 4A is 0 dB)

As the input power of the power amplifier apparatus 1 further increases, both the main path and the peak path reach the saturation state, and both the voltages reach full swing. In this case, the power amplifier apparatus 1 achieves a second high-power point in the working process. As shown in FIG. 4A, a power back-off point of a power amplifier apparatus corresponding to the second high-power point is 0 dB. In this case, the power amplifier apparatus 1 is in a maximum output power state in the entire system.

It can be learned that, when the power amplifier apparatus 1 works away from the high-power region and enters the medium-power region (with a power back-off amount of -9.5 dB to 0 dB shown in FIG. 4A), high efficiency of the power amplifier and low power consumption may still be ensured.

**FIG. 4B** shows an example in which a first power amplifier unit 2 is an auxiliary power amplifier unit, a second power amplifier unit 3 is a main power amplifier unit, the first power amplifier unit includes one power amplifier, the second power amplifier unit includes one power amplifier, the first power amplifier unit is an auxiliary power amplifier unit, the second power amplifier unit is a main power amplifier unit, and a power ratio of maximum output power of the first power amplifier unit to maximum output power of the second power amplifier unit is 1:1.

In comparison with FIG. 4A, a difference in the diagram of the efficiency curve shown in FIG. 4B lies in that a power back-off point corresponding to a first high-power point of the power amplifier apparatus 1 is -11 dB, a low-power region of the power amplifier apparatus 1 shown in FIG. 4B is a region in which normalized output power is less than -11 dB, and a medium-power region is a region in which normalized output power Pout is between -11 dB and 0 dB. It can be learned from the content shown in FIG. 4A and FIG. 4B that, the main power amplifier unit in the power amplifier apparatus 1 provided in embodiments of this application is flexibly set, and any one of M power amplifier units may be used as a main power amplifier unit. A large power back-off amount of the power amplifier apparatus 1 can be implemented by setting a power ratio of the power amplifier units.

In addition, refer to FIG. 3A, FIG. 3B, and FIG. 3C. In comparison with a signal sent by the second power amplifier unit, a signal sent by the first power amplifier unit needs to additionally pass through a link from the first port 41 to the second port 42. Therefore, in comparison with a solution in which the first power amplifier unit is used as a main power amplifier unit, if the first power amplifier unit is used as an auxiliary power amplifier unit, the first power amplifier unit may be enabled later, to reduce a quantity of signals that need to be transmitted on the link from the first port 41 to the second port 42, and further reduce an insertion loss of an output matching network.

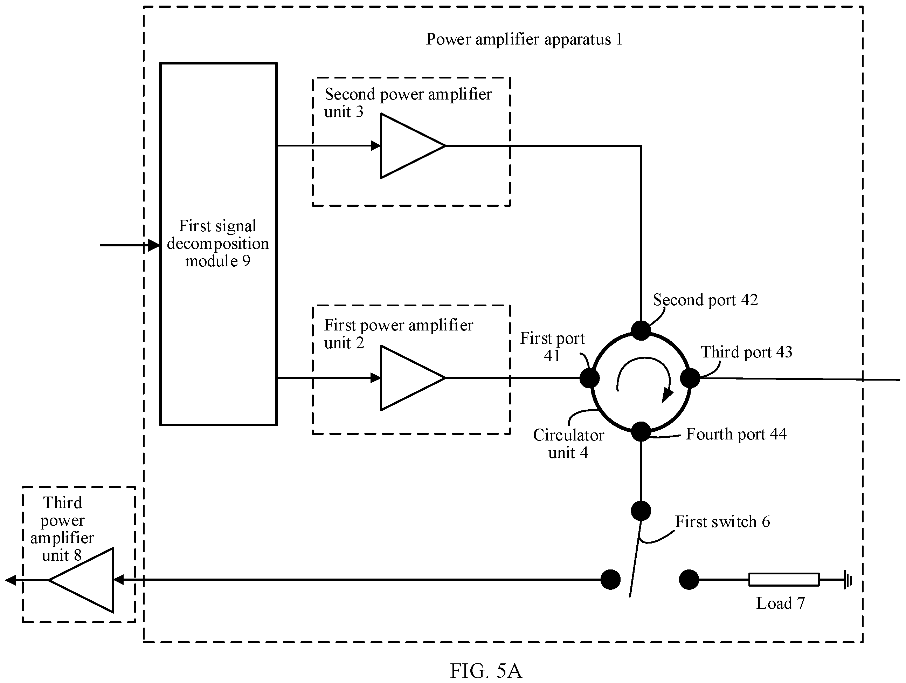

Based on embodiments shown in FIG. 1, FIG. 2A, FIG. 2B, FIG. 3A, FIG. 3B, FIG. 3C, FIG. 4A, and FIG. 4B, and the foregoing other content, **FIG. 5A** is an example diagram of another possible structure of a communication system according to an embodiment of this application. The embodiment shown in FIG. 5A may be considered as an extended embodiment of the foregoing embodiments of FIG. 3A, FIG. 3B, and FIG. 3C. FIG. 5A uses an architecture of the power amplifier apparatus 1 shown in FIG. 3A as an example for illustration. The embodiment in FIG. 5A is also applicable to the foregoing embodiment shown in FIG. 3B. In this case, it may be understood as that a fourth port 44 in the power amplifier apparatus 1 in the embodiment shown in FIG. 5A is directly connected to a load 7, the power amplifier apparatus 1 does not include a first switch 6, and other content is applicable to embodiments shown in FIG. 3A and FIG. 3B. Details are not described subsequently again. The embodiment in FIG. 5A is also applicable to the foregoing embodiment shown in FIG. 3C. In this case, it may be understood as that the power amplifier apparatus 1 in the embodiment shown in FIG. 5A does not include a fourth port 44, a first switch 6, or a load 7, and other content is applicable to embodiments shown in FIG. 3A and FIG. 3C. Details are not described subsequently again.

Refer to FIG. 5A. In a possible implementation, a third port 43 of a circulator unit 4 in this embodiment of this application may be connected to an antenna. For example, the third port 43 of the circulator unit 4 may be used as an output port of the power amplifier apparatus, the third port may be connected to a filter, and the filter is connected to the antenna. In this case, a signal received through the third port 43 of the circulator unit 4 from another port of the circulator unit may be sent to the antenna through the third port 43, to be transmitted via the antenna. A signal received by the antenna may be transmitted to the fourth port 44 through the third port 43 of the circulator unit 4, and then transmitted to a third power amplifier unit 8 through the fourth port 44.

The power amplifier apparatus 1 shown in FIG. 5A further includes a first signal decomposition module 9. It may also be understood as that the power amplifier apparatus 1 shown in FIG. 3A, FIG. 3B, or FIG. 3C may also include the first signal decomposition module 9.

An output port of the first signal decomposition module 9 is separately connected to an input port of a first power amplifier unit 2 and an input port of a second power amplifier unit 3. The first signal decomposition module 9 is configured to obtain at least two paths of signals based on a received radio frequency signal, and respectively input the signals in the at least two paths of signals into the first power amplifier unit 2 and the second power amplifier unit 3.

In a possible implementation, the first signal decomposition module 9 is configured to control amplitudes and/or phases of the two paths of signals input into the first power amplifier unit 2 and the second power amplifier unit 3. The first signal decomposition module 9 may perform digital amplitude modulation and phase modulation or analog amplitude modulation and phase modulation on the two paths of signals input into the first power amplifier unit 2 and the second power amplifier unit 3.

It can be learned from the diagrams of FIG. 4A and FIG. 4B that, although the power amplifier apparatus 1 can improve efficiency of the medium-power region, there is an "efficiency dip" in the medium-power region. To alleviate an "efficiency dip" problem in the medium-power region, this embodiment of this application provides a possible implementation. In this implementation, the first power amplifier unit 2 is a main power amplifier, and the second power amplifier unit 3 is an auxiliary power amplifier. The first signal decomposition module 9 is specifically configured to:
after the second power amplifier unit 3 is enabled, control a value of a current of the signal input into the second power amplifier unit 3 to increase as output power of the power amplifier apparatus 1 increases, and
control a value of a current of the signal input into the first power amplifier unit 2 to decrease as the output power of the power amplifier apparatus 1 increases; and when the value of the current of the signal input into the first power amplifier unit 2 is less than a preset first current value, control a phase of the current of the signal input into the first power amplifier unit 2 to rotate by 180 degrees, and control the value of the current of the signal input into the first power amplifier unit 2 to increase as the output power of the power amplifier apparatus 1 increases.

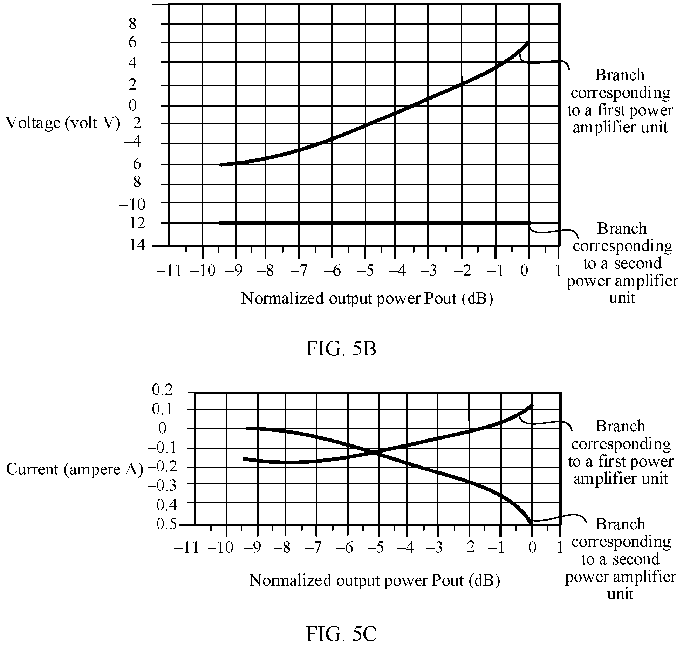

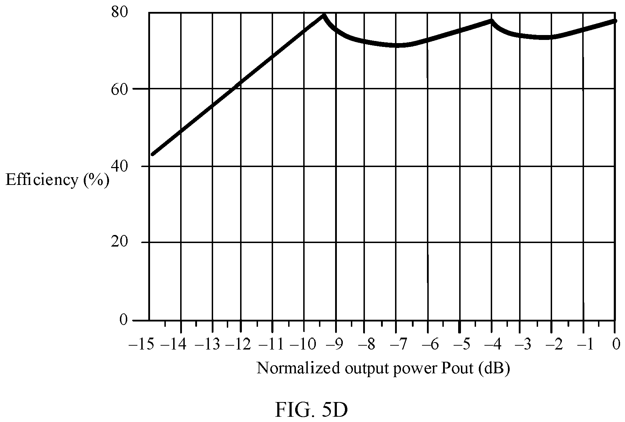

Based on the embodiment shown in FIG. 5A, **FIG. 5B** is an example curve diagram of voltages of the first power amplifier unit and the second power amplifier unit in FIG. 5A and normalized output power Pout, **FIG. 5C** is an example curve diagram of currents of the first power amplifier unit and the second power amplifier unit in FIG. 5A and normalized output power Pout, and **FIG. 5D** is an example curve diagram of efficiency of the first power amplifier unit and the second power amplifier unit in FIG. 5A and normalized output power Pout.

As shown in **FIG. 5B and FIG. 5C****,** after the second power amplifier unit 3 is enabled, the second power amplifier unit 3 is actively pulled by the first power amplifier unit 2, so that a working voltage of the second power amplifier unit 3 keeps in a full swing state, in other words, an output voltage amplitude of the second power amplifier unit 3 is constant, and a current of the second power amplifier unit 3 increases as the output power of the power amplifier apparatus 1 increases.

Because a characteristic of the circulator unit 4 is that a signal entering any port of the circulator unit 4 is sequentially transmitted to a next port or a plurality of ports in a direction determined by a static bias magnetic field, and a signal received by the circulator unit 4 through a first port may be transmitted to a second port 42 and the third port 43 (for example, the signal received by the circulator unit 4 through the first port may be sequentially transmitted to the second port 42 and the third port 43), the first power amplifier unit 2 may be considered to be in an isolated state relative to the second power amplifier unit 3. In other words, impedance of a port on a side of the first power amplifier unit 2 may be close to a constant value. Therefore, a voltage of a signal of the first power amplifier unit 2 increases as the output power of the power amplifier apparatus 1 increases.

The first signal decomposition module 9 controls a current of the signal received by the first power amplifier unit 2 to first decrease as the output power of the power amplifier apparatus 1 increases. When the current decreases to zero ampere (A) (in FIG. 5B, an example in which the preset first current value is 0 A is used for illustration), a phase is rotated by 180 degrees and increases as the output power of the power amplifier apparatus 1 increases.

Refer to **FIG. 5D****.** When the first signal decomposition module 9 digitally controls, based on curves shown in FIG. 5C, the amplitudes and the phases of the two paths of signals input into the first power amplifier unit 2 and the second power amplifier unit 3 (where in this case, the power amplifier apparatus is in a dual-input mode), an additional efficiency peak point may be generated in the medium-power region, to alleviate the "efficiency dip". In comparison with FIG. 4A, in FIG. 5D, an additional efficiency peak point may be generated at a location in which the normalized output power Pout in the medium-power region is -4 dB, to alleviate the "efficiency dip" problem in the medium-power region, and improve overall performance of the power amplifier apparatus.

It should be noted that, during actual application, amplitudes and phases of the currents of the signals input into the first power amplifier unit and the second power amplifier unit may be adjusted in real time based on the output power of the power amplifier apparatus 1. FIG. 5C merely provides a possible example, and adjustment may be performed based on an actual situation during actual application.

The solutions shown in FIG. 5A, FIG. 5B, and FIG. 5C may also be applicable to the power amplifier apparatus 1 shown in FIG. 3B or FIG. 3C. In this case, the first power amplifier unit 2 and the second power amplifier unit 3 in FIG. 3B or FIG. 3C may also be connected to the first signal decomposition module 9. The first signal decomposition module 9 digitally controls, based on curves shown in FIG. 5C, the amplitudes and the phases of the two paths of signals input into the first power amplifier unit 2 and the second power amplifier unit 3. Therefore, an additional efficiency peak point may be generated in the medium-power region of the power amplifier apparatus 1 in FIG. 3B or FIG. 3C, to alleviate the "efficiency dip". Related content is similar to the foregoing content, and details are not described again.

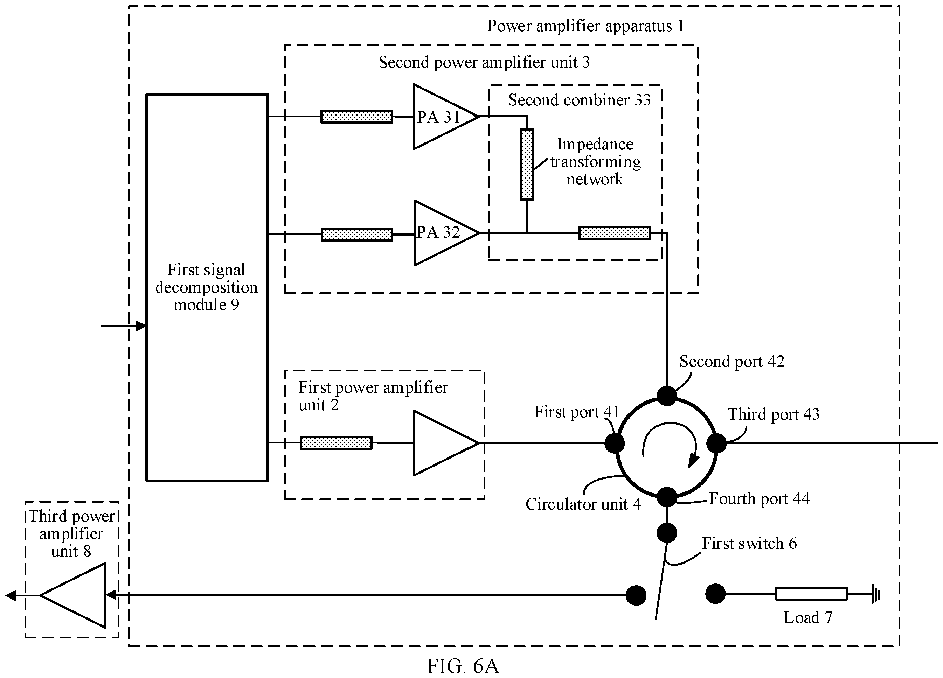

Based on embodiments shown in FIG. 1, FIG. 2A, FIG. 2B, FIG. 3A, FIG. 3B, FIG. 3C, FIG. 4A, FIG. 4B, FIG. 5A, FIG. 5B, FIG. 5C, and FIG. 5D, and the foregoing other content, FIG. 6A is an example diagram of another possible structure of a communication system according to an embodiment of this application. The embodiment shown in FIG. 6A may be considered as an extended embodiment of the foregoing embodiment of FIG. 3A, FIG. 3B, or FIG. 3C, or may be used in combination with the foregoing embodiments shown in FIG. 5A, FIG. 5B, FIG. 5C, and FIG. 5D. In FIG. 6A, an architecture of the power amplifier apparatus 1 shown in FIG. 3A is used as an example for illustration. The embodiment in FIG. 6A is also applicable to the foregoing embodiment shown in FIG. 3B or FIG. 3C.

As shown in FIG. 6A, a second power amplifier unit includes N2 power amplifier subunits and a second combiner 33. N2 is an integer greater than 1. Any one of the N2 power amplifier subunits may include one or more power amplifiers. In FIG. 6A, an example in which N2 is 2, one of the power amplifier subunits includes a PA 31, and the other power amplifier subunit includes a PA 32 is used for illustration.

Output ports of the N2 power amplifier subunits are connected to an input port of the second combiner 33, and an output port of the second combiner 33 is connected to a second port 42 of a circulator unit 4. Each of the N2 power amplifier subunits is configured to amplify a received signal, and input an amplified signal into the second combiner 33. The second combiner 33 is configured to input the signal received from the power amplifier subunit in the N2 power amplifier subunits into the second port 42. As shown in FIG. 6A, the second combiner 33 may include one or more impedance transforming networks (for example, quarter-wave impedance transforming networks).

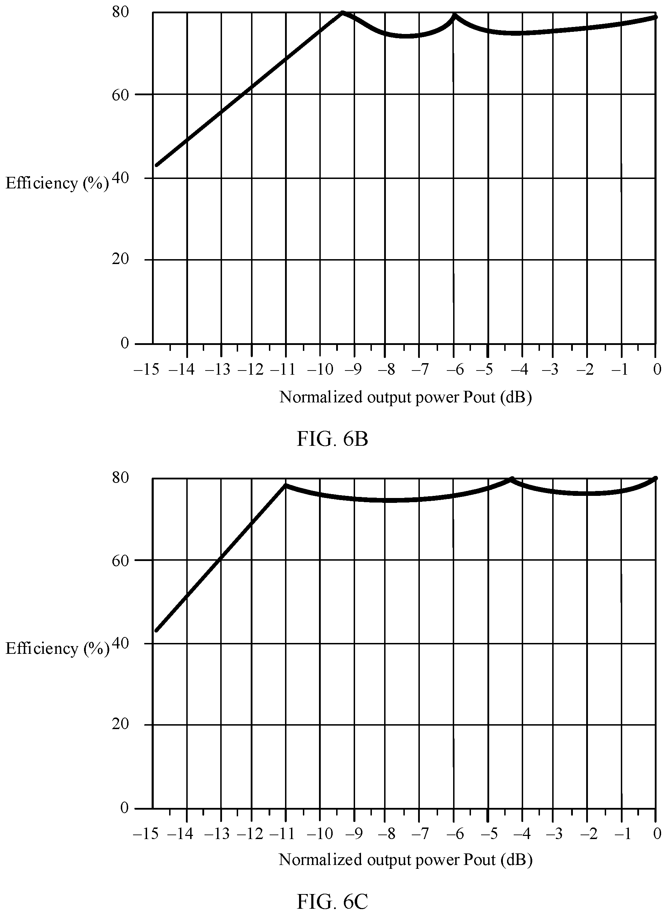

Because the second power amplifier unit includes a plurality of power amplifier subunits, an additional efficiency peak point may be generated in a medium-power region, to alleviate an "efficiency dip" problem. **FIG. 6B and FIG. 6C** are example diagrams of several possible efficiency curves of the power amplifier apparatus 1 in FIG. 6A.

**FIG. 6B** is an example diagram of a possible efficiency curve of the power amplifier apparatus 1 when a first power amplifier unit 2 in FIG. 6A is a main power amplifier unit. In FIG. 6B, an example in which a power ratio of the first power amplifier unit, the PA 31, and the PA 32 is 1:5:3 is used for illustration. As shown in FIG. 6B, in comparison with FIG. 4A, in FIG. 6B, an additional efficiency peak point may be generated at a location in which normalized output power Pout in the medium-power region is -6 dB, to alleviate the "efficiency dip" problem in the medium-power region, and improve overall performance of the power amplifier apparatus.

**FIG. 6C** is an example diagram of a possible efficiency curve of the power amplifier apparatus 1 when the PA 31 in the second power amplifier unit 3 in FIG. 6A is a main power amplifier unit. In FIG. 6C, an example in which a power ratio of the PA 31, the PA 32, and the first power amplifier unit is 1:4:1 is used for illustration. As shown in FIG. 6C, in comparison with FIG. 4B, in FIG. 6C, an additional efficiency peak point may be generated at a location in which normalized output power Pout in the medium-power region is -4.5 dB, to alleviate the "efficiency dip" problem in the medium-power region, and improve overall performance of the power amplifier apparatus.

When N2 is equal to 2, the second power amplifier unit 3 may also be considered as using a DHT architecture. In this case, the solution can be more compatible with the conventional technology. In this embodiment of this application, a power ratio of the first power amplifier unit and the N2 power amplifier subunits may be determined based on a back-off amount corresponding to a set efficiency peak point of a power amplifier apparatus. The set efficiency peak point of the power amplifier apparatus is a peak point in the medium-power region, for example, a peak point corresponding to -4.5 dB shown in FIG. 6C. In this case, a user may set the power ratio of the first power amplifier unit and the N2 power amplifier subunits based on a back-off amount corresponding to an actually required efficiency peak point, to satisfy diversified requirements of the user.

FIG. 6A further shows an example of impedance transforming networks in the first power amplifier unit 2 and the second power amplifier unit 3. The impedance transforming networks may implement impedance matching of a main power amplifier unit in a high-impedance state (a low-power region) and impedance pulling inverse of the main power amplifier unit after an auxiliary power amplifier unit is enabled. A quantity and locations of the impedance transforming networks shown in FIG. 6A are merely examples. In an actual application function, the impedance transforming network may be deployed as required.

The solutions shown in FIG. 6A, FIG. 6B, and FIG. 6C may also be applicable to the power amplifier apparatus 1 shown in FIG. 3B or FIG. 3C. In this case, the first power amplifier unit 2 and the second power amplifier unit 3 in FIG. 3B or FIG. 3C may also be the first power amplifier unit 2 and the second power amplifier unit 3 in FIG. 6A. Therefore, an additional efficiency peak point may be generated in the medium-power region of the power amplifier apparatus 1, to alleviate the "efficiency dip". Related content is similar to the foregoing content, and details are not described again.

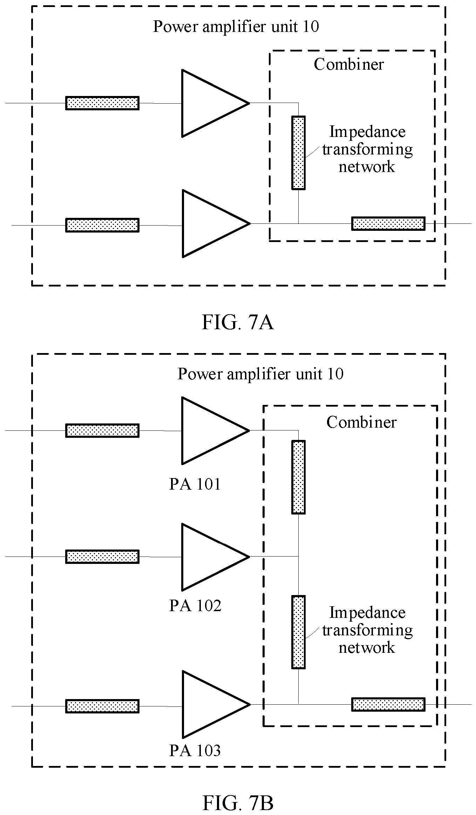

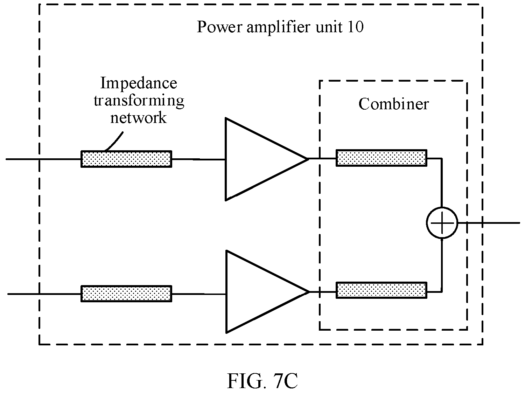

Based on embodiments shown in FIG. 1, FIG. 2A, FIG. 2B, FIG. 3A, FIG. 3B, FIG. 3C, FIG. 4A, FIG. 4B, FIG. 5A, FIG. 5B, FIG. 5C, FIG. 5D, FIG. 6A, FIG. 6B, and FIG. 6C, and the foregoing other content, **FIG. 7A, FIG. 7B****, and** **FIG. 7C** are example diagrams of several possible structures of a power amplifier unit 10 in M power amplifier units according to embodiments of this application. The power amplifier unit 10 shown in any one or more of FIG. 7A, FIG. 7B, and FIG. 7C may be a diagram of a structure of any one or more of the M power amplifier units. For example, the power amplifier unit in any one of FIG. 7A, FIG. 7B, and FIG. 7C may be the first power amplifier unit 2 in FIG. 3A, FIG. 3B, and FIG. 3C, or may be the second power amplifier unit 3 in FIG. 3A, FIG. 3B, and FIG. 3C.

As shown in **FIG. 7A****,** the power amplifier unit 10 of a power amplifier apparatus 1 may include two power amplifier subunits. Each power amplifier subunit includes one power amplifier. The two power amplifier subunits are combined by using a combiner. A diagram of an architecture of the power amplifier unit shown in FIG. 7A may also be considered as an architecture of two-way DHT PA\Sequential PA\Chireix PA.

As shown in **FIG. 7B****,** the power amplifier unit 10 of a power amplifier apparatus 1 may include three power amplifier subunits. Each power amplifier subunit includes one power amplifier. The three power amplifier subunits are respectively a PA 101, a PA 102, and a PA 103. The three power amplifier subunits are combined into one channel by using a combiner. For example, the PA 101 and the PA 102 are combined with the PA 103. A diagram of an architecture of the power amplifier unit shown in FIG. 7B may also be considered as an architecture of multi-way Doherty PA\Sequential PA\Chireix PA.

As shown in **FIG. 7C****,** the power amplifier unit 10 of a power amplifier apparatus 1 may include two power amplifier subunits. Each power amplifier subunit includes one power amplifier. The two power amplifier subunits are combined by using a combiner. A diagram of an architecture of the power amplifier unit shown in FIG. 7C may also be considered as an architecture of an outphasing PA. In the architecture, two power amplifier branches combined by using the combiner may be understood as an outphasing (outphasing) combination.

In this embodiment of this application, any one of the M power amplifier units of the power amplifier apparatus 1 may alternatively be of an architecture of an envelope tracking power (envelope tracking power, ET) PA.

The power amplifier unit 10 shown in any one of FIG. 7A, FIG. 7B, and FIG. 7C may be single-input, or may be multiple-input. When the power amplifier unit 10 shown in FIG. 7A, FIG. 7B, and FIG. 7C is single-input, a phase and an amplitude of a signal received by each power amplifier in the power amplifier unit 10 are fixed and nonadjustable. In this case, a signal decomposition module (for example, a first signal decomposition module 9) connected to the power amplifier unit 10 may be a radio frequency analog circuit. When the power amplifier unit 10 shown in FIG. 7A, FIG. 7B, and FIG. 7C is multiple-input, a phase and an amplitude of a signal received by each power amplifier in the power amplifier unit 10 may be flexibly adjustable. In this case, a signal received by the power amplifier unit 10 from a signal decomposition module (for example, a first signal decomposition module 9) may be a digital excitation radio frequency signal. An input port of the power amplifier unit 10 shown in FIG. 7A, FIG. 7B, and FIG. 7C may be connected to an output port of the first signal decomposition module 9, and an output port of the power amplifier unit 10 may be connected to a port of a circulator unit 4.

Because one or more of the M power amplifier units may use a high-efficiency power amplifier architecture shown in any one of FIG. 7A, FIG. 7B, and FIG. 7C, the power amplifier apparatus 1 may add an efficiency peak point of the power amplifier apparatus 1, to alleviate an "efficiency dip" problem in a medium-power region, and improve overall performance of the power amplifier apparatus.

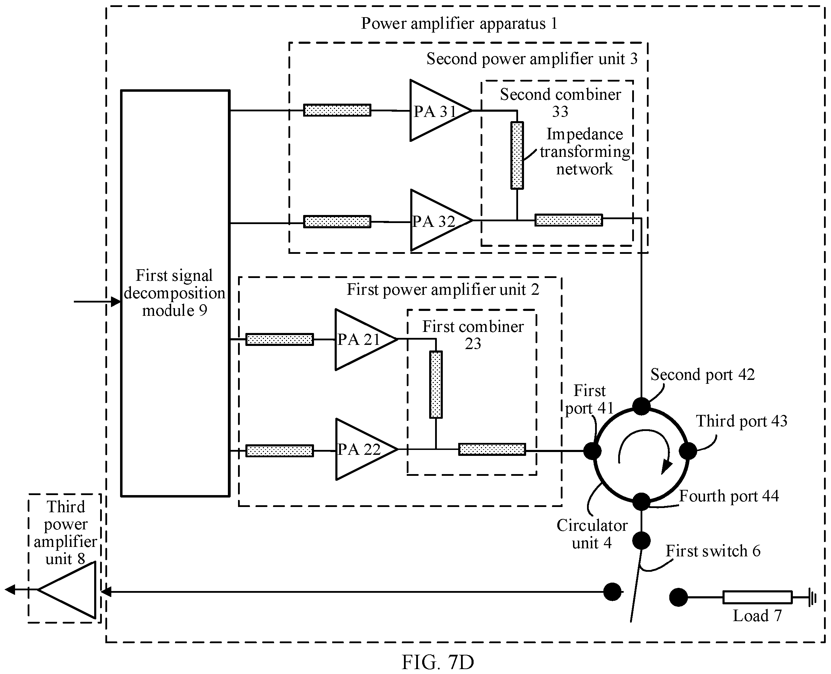

Based on embodiments shown in FIG. 1, FIG. 2A, FIG. 2B, FIG. 3A, FIG. 3B, FIG. 3C, FIG. 4A, FIG. 4B, FIG. 5A, FIG. 5B, FIG. 5C, FIG. 5D, FIG. 6A, FIG. 6B, FIG. 6C, FIG. 7A, FIG. 7B, and FIG. 7C, and the foregoing other content, **FIG. 7D** is an example diagram of an architecture of another possible communication system to which an embodiment of this application is applicable. FIG. 7D may be considered as an extended embodiment of the foregoing embodiment shown in FIG. 3A or FIG. 6A.

In comparison with FIG. 6A, a first power amplifier unit 2 in FIG. 7D includes N1 power amplifier subunits and a first combiner. N1 is an integer greater than 1. Any one of the N1 power amplifier subunits may include one or more power amplifiers. In FIG. 7D, an example in which N1 is 2, one of the power amplifier subunits includes a PA 21, and the other power amplifier subunit includes a PA 22 is used for illustration.

Output ports of the N1 power amplifier subunits are connected to an input port of the first combiner 23, and an output port of the first combiner 23 is connected to a first port 41 of a circulator unit 4. The N1 power amplifier subunits are configured to amplify a received signal, and input an amplified signal into the first combiner 23. The first combiner 23 is configured to input the signal received from the power amplifier subunit in the N1 power amplifier subunits into the first port 41. As shown in FIG. 7D, the first combiner 23 may include one or more impedance transforming networks (for example, quarter-wave impedance transforming networks).

Because the first power amplifier unit includes a plurality of power amplifier subunits, an additional efficiency peak point may be generated in a medium-power region, to alleviate an "efficiency dip". The solution shown in FIG. 7D may also be applicable to the power amplifier apparatus 1 shown in FIG. 3B or FIG. 3C. In this case, the first power amplifier unit 2 and the second power amplifier unit 3 in FIG. 3B or FIG. 3C may also be the first power amplifier unit 2 and the second power amplifier unit 3 in FIG. 7D. Therefore, an additional efficiency peak point may be generated in the medium-power region of the power amplifier apparatus 1, to alleviate the "efficiency dip". Related content is similar to the foregoing content, and details are not described again.

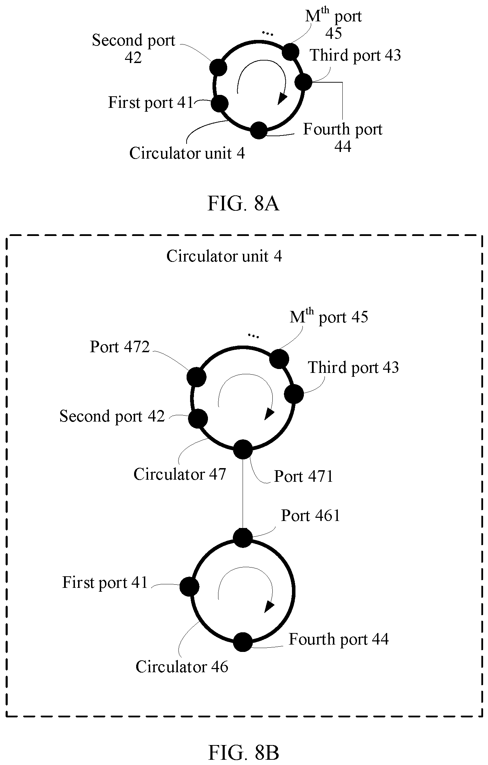

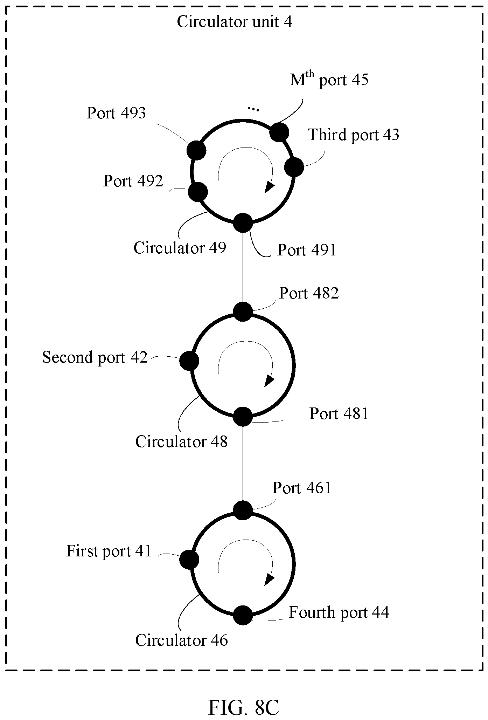

Based on embodiments shown in FIG. 1, FIG. 2A, FIG. 2B, FIG. 3A, FIG. 3B, FIG. 3C, FIG. 4A, FIG. 4B, FIG. 5A, FIG. 5B, FIG. 5C, FIG. 5D, FIG. 6A, FIG. 6B, FIG. 6C, FIG. 7A, FIG. 7B, FIG. 7C, and FIG. 7D, and the foregoing other content, **FIG. 8A, FIG. 8B****, and** **FIG. 8C** are example diagrams of several possible structures of a circulator unit 4 according to embodiments of this application. In FIG. 8A, FIG. 8B, and FIG. 8C, the circulator unit 4 in the power amplifier apparatus 1 shown in FIG. 3A is used as an example for illustration. Embodiments in FIG. 8A, FIG. 8B, and FIG. 8C are also applicable to the foregoing embodiment shown in FIG. 3B or FIG. 3C.

As shown in **FIG. 8A****,** the circulator unit 4 may include one circulator (where the circulator may be referred to as a first circulator). The circulator includes (M+2) ports. The M ports may be connected to M power amplifier units in one-to-one correspondence. For example, one of the M ports is connected to one of the M power amplifier units, and one of the M power amplifier units is connected to one of the M ports. In a possible implementation, M is an integer greater than 2. The circulator unit further includes (M-2) ports connected to (M-2) power amplifier units other than a first power amplifier unit and a second power amplifier unit in the M power amplifier units. FIG. 8A shows an example of an M^{th} port 45. The M ports are included in total along a signal transmission direction in the circulator unit 4 from a first port 41 to the M^{th} port 45. A third port 43 is located behind the M^{th} port 45, and a fourth port 44 is located behind the third port 43. In this case, a signal received through the first port 41 to the M^{th} port 45 may be transmitted to the third port. A signal received through the third port from an antenna may be transmitted to the fourth port 44.

As shown in **FIG. 8B****,** the circulator unit 4 may alternatively include a plurality of circulators, for example, include a circulator 46 and a circulator 47 (where the circulator 46 may also be referred to as a first circulator, and the circulator 47 may also be referred to as a second circulator). The circulator 46 is a circulator with three ports. The circulator 46 includes a first port 41, a port 461, and a fourth port 44. The circulator 47 includes a port 471, a second port 42, a port 472, ..., and an M^{th} port 45. The circulator 47 includes (M-1) ports in total along a signal transmission direction in the circulator 47 from the second port 42 to the Mth port 45. The (M-1) ports plus the first port 41 gives a total of M ports, and the M ports may be connected to M power amplifier units in one-to-one correspondence. For example, one of the M ports is connected to one of the M power amplifier units, and one of the M power amplifier units is connected to one of the M ports. In addition, the port 461 of the circulator 46 is connected to the port 471. In this case, a signal received through the first port 41 may be transmitted to the port 471 through the port 461. Further, in the circulator 47, the signal received through the port 471, the second port 42, and the port 472 to the M^{th} port 45 may be transmitted to a third port. A signal received through the third port from an antenna may be transmitted to the port 461 through the port 471, and further transmitted to the fourth port 44.

As shown in **FIG. 8C****,** the circulator unit 4 may alternatively include more than two circulators. For example, the circulator unit 4 includes a circulator 46, a circulator 48, and a circulator 49. The circulator 46 and the circulator 48 each are a circulator with three ports. The circulator 46 includes a first port 41, a port 461, and a fourth port 44. The circulator 48 includes a port 481, a second port 42, and a port 482. The circulator 49 includes a port 491, a port 492, a port 493, ..., and an M^{th} port 45. The circulator 49 includes (M-2) ports in total along a signal transmission direction in the circulator 49 from the port 492 to the M^{th} port 45. The (M-2) ports plus the first port 41 and the second port 42 gives a total of M ports, and the M ports may be connected to M power amplifier units in one-to-one correspondence. For example, one of the M ports is connected to one of the M power amplifier units, and one of the M power amplifier units is connected to one of the M ports. In addition, the port 461 of the circulator 46 is connected to the port 481, and the port 482 is connected to the port 491. In this case, a signal received through the first port 41 may be transmitted to the port 481 through the port 461. Further, in the circulator 48, the signal received through the port 481 and the second port 42 may be transmitted to the port 491 through the port 482. In the circulator 49, a signal received through the port 491, the port 492, and the port 493 to the M^{th} port 45 may be transmitted to a third port. A signal received through the third port from an antenna may be transmitted to the port 482 through the port 491, further transmitted to the port 461 through the port 481, and then transmitted to the fourth port 44.

With reference to FIG. 8C, in a possible implementation, the M power amplifier units connected to the M ports of the circulator unit 4 are connected to a first signal decomposition module 9. Along a signal transmission direction of the circulator unit 4, a first power amplifier unit 2 connected to the first port 41 may perform load modulation on a second power amplifier unit 3 connected to the second port 42, and further perform load modulation on a power amplifier unit connected to the port 492, a power amplifier unit connected to the port 493, ..., and a power amplifier unit connected to the M^{th} port 45. Similarly, the second power amplifier unit 3 connected to the second port 42 may perform load modulation on the power amplifier unit connected to the port 492, the power amplifier unit connected to the port 493, ..., and the power amplifier unit connected to the M^{th} port 45. In other words, along the signal transmission direction of the circulator unit 4, a power amplifier unit may perform load modulation on all power amplifier units after the power amplifier unit. In this case, a plurality of efficiency peak points may be generated, to alleviate an "efficiency dip" problem in a medium-power region, and improve overall performance of the power amplifier apparatus.

In this embodiment of this application, the circulator unit 4 may further include more circulators, for example, five, six, or more circulators. The circulator unit 4 may implement a function of outputting, through the third port, signals of the M ports connected to the M power amplifier units. In another possible implementation, the circulator unit may implement a function of outputting, through the fourth port, the signal received through the third port from the antenna. A specific arrangement manner of the plurality of circulators in the circulator unit 4 may be flexibly set based on an actual application scenario.

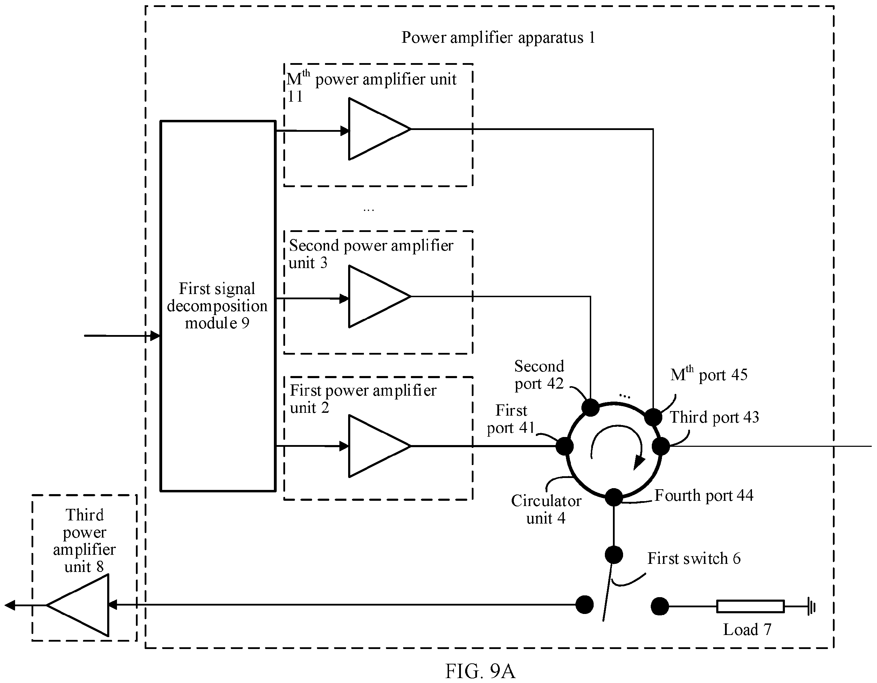

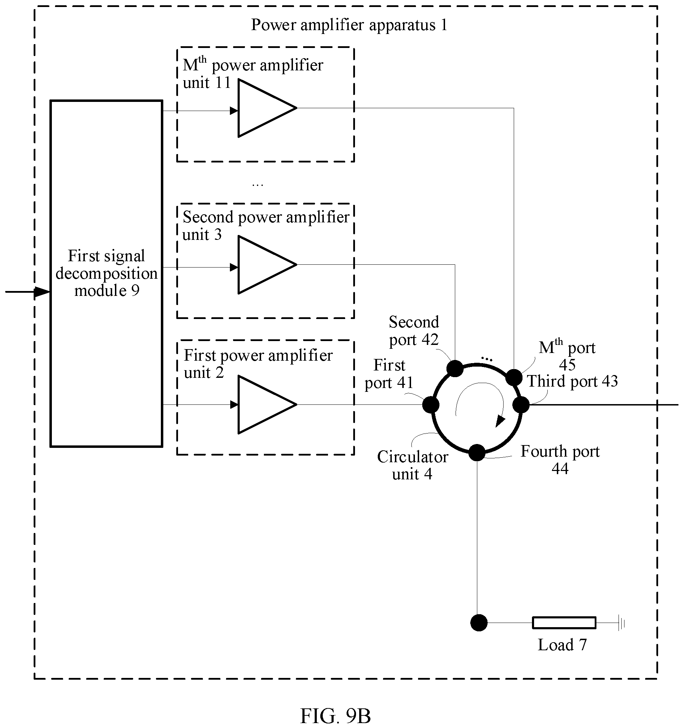

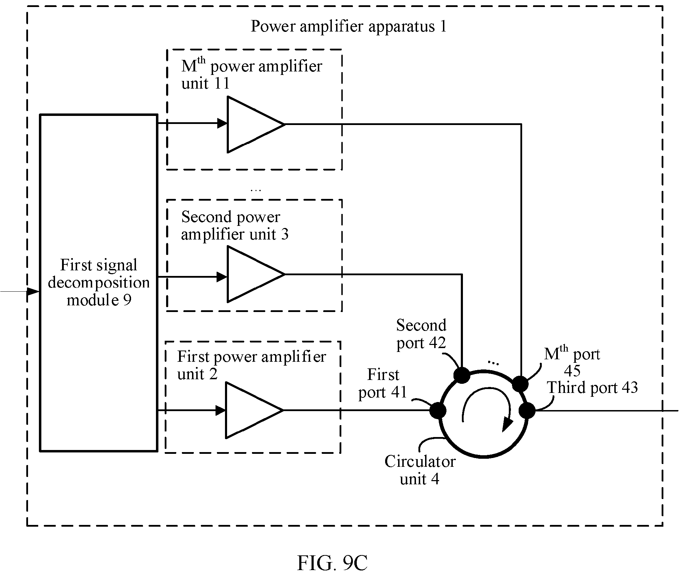

Based on embodiments shown in FIG. 1, FIG. 2A, FIG. 2B, FIG. 3A, FIG. 3B, FIG. 3C, FIG. 4A, FIG. 4B, FIG. 5A, FIG. 5B, FIG. 5C, FIG. 5D, FIG. 6A, FIG. 6B, FIG. 6C, FIG. 7A, FIG. 7B, FIG. 7C, FIG. 7D, FIG. 8A, FIG. 8B, and FIG. 8C, and foregoing other content, **FIG. 9A****,** **FIG. 9B****, and** **FIG. 9C** are example diagrams of architectures of several communication systems to which embodiments of this application are applicable. FIG. 9A, FIG. 9B, and FIG. 9C show examples of a case in which M is greater than 2. FIG. 9A may be considered as an extended embodiment of the foregoing embodiment shown in FIG. 3A. FIG. 9B may be considered as an extended embodiment of the foregoing embodiment shown in FIG. 3B. FIG. 9C may be considered as an extended embodiment of the foregoing embodiment shown in FIG. 3C. As shown in FIG. 9A, FIG. 9B, and FIG. 9C, M power amplifier units may be respectively connected to M ports of a circulator unit. Input ends of the M power amplifier units may be separately connected to a first signal decomposition module 9. The circulator unit 4 in FIG. 9A, FIG. 9B, and FIG. 9C may implement a function of outputting, through a third port, signals of the M ports connected to the M power amplifier units. In FIG. 9A, the circulator unit may further implement a function of outputting, through a fourth port, a signal received through the third port from an antenna. Because a power amplifier apparatus 1 may include a large quantity of power amplifier units, a large quantity of efficiency peak points may be generated. Therefore, an "efficiency dip" problem may be alleviated, and overall performance of the power amplifier apparatus 1 may be improved.

Any one of the M power amplifier units shown in FIG. 9A, FIG. 9B, and FIG. 9C may be replaced with another high-efficiency power amplifier architecture, for example, may be replaced with the power amplifier unit in any one of FIG. 7A, FIG. 7B, or FIG. 7C. An input signal of any power amplifier unit may be in a single-input mode or a multi-input mode. The circulator unit 4 in any one of FIG. 9A, FIG. 9B, and FIG. 9C may also be the circulator unit in any one of FIG. 8A, FIG. 8B, and FIG. 8C.

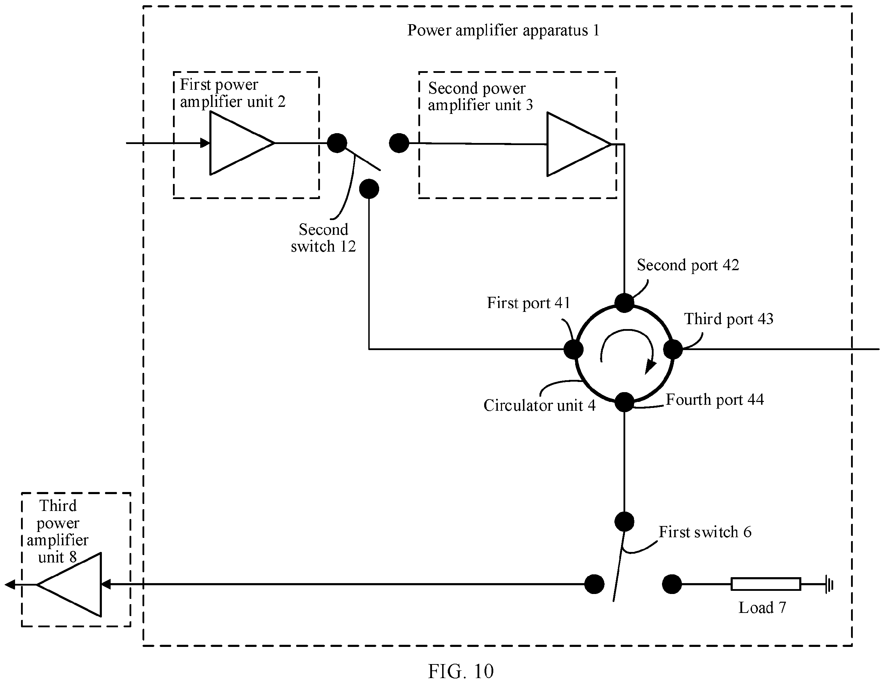

Based on embodiments shown in FIG. 1 and FIG. 2A, and the foregoing other content, FIG. **10** is an example diagram of a possible structure of another power amplifier apparatus 1 according to an embodiment of this application. The power amplifier apparatus 1 shown in FIG. 10 may be the power amplifier apparatus 1 shown in FIG. 2A.

As shown in FIG. 10, the power amplifier apparatus 1 includes M power amplifier units and a circulator unit 4, and the M power amplifier units are connected to the circulator unit 4. M is an integer greater than 1, and M may be 2, or may be greater than 2. In FIG. 10, an example in which the M power amplifier units include a first power amplifier unit 2 and a second power amplifier unit 3 is used for illustration.

Refer to FIG. 10. The circulator unit 4 includes a first port 41, a second port 42, a third port 43, and a fourth port 44. An output port of the second power amplifier unit 3 is connected to the second port 42. The fourth port 44 of the circulator unit 4 is selectively connected to a load 7 or a third power amplifier unit 8 by using a first switch 6.

An output port of the first power amplifier unit 2 is selectively connected to the first port 41 of the circulator unit 4 or an input port of a second power amplifier unit 3 by using a second switch 12.

It may also be understood as that, in comparison with the foregoing solution in FIG. 3A, a difference in FIG. 10 lies in that the first power amplifier unit 2 in FIG. 10 is not directly connected to the first port 41 of the circulator unit 4, but is connected to the first port 41 and the input port of the second power amplifier unit 3 by using the second switch.

Because the second switch 12 is added between the first power amplifier unit 2 and the second power amplifier unit 3, when the first power amplifier unit 2 is connected to the second power amplifier unit 3 by using the second switch, a signal may be amplified by the first power amplifier unit 2 and then enter the second power amplifier unit 3, so that the second power amplifier unit 3 further amplifies the signal. Because the signal may be amplified by the first power amplifier unit 2 and the second power amplifier unit 3, a back-off amount of the power amplifier apparatus 1 may be increased, and back-off efficiency is improved.

It should be noted that the embodiment shown in FIG. 10 may be used in combination with the foregoing content. For example, any power amplifier unit in FIG. 10 may include one or more power amplifiers. For example, any power amplifier unit in the power amplifier apparatus 1 in FIG. 10 may be the power amplifier unit in any one of FIG. 7A, FIG. 7B, or FIG. 7C. For another example, the circulator unit 4 in FIG. 10 may include one or more circulators. For example, the circulator unit 4 in FIG. 10 may be the circulator unit in any one of FIG. 8A, FIG. 8B, or FIG. 8C.

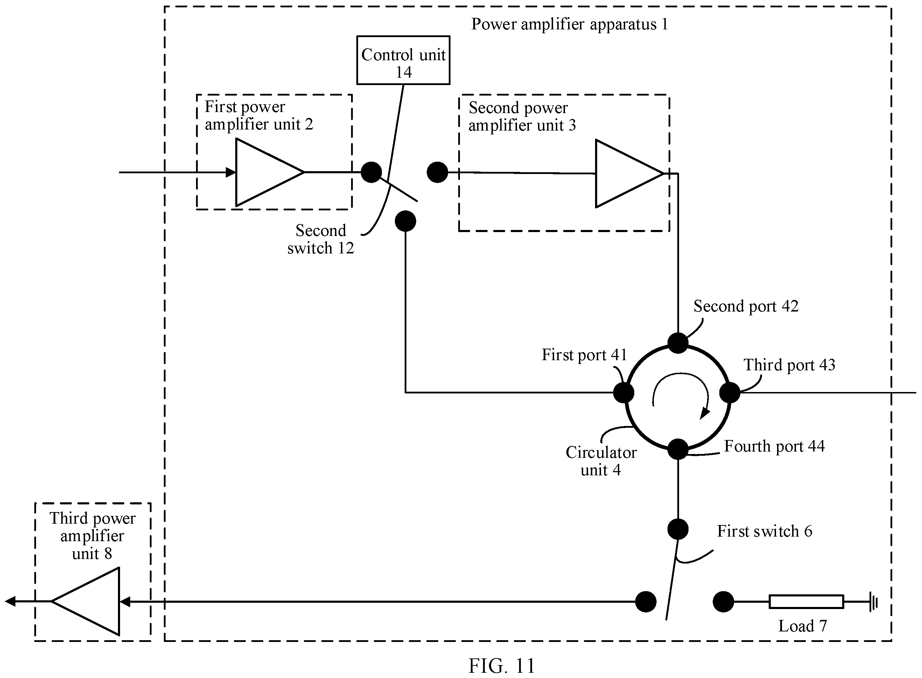

Based on embodiments shown in FIG. 1, FIG. 2A, and FIG. 10, and the foregoing other content, **FIG. 11** is an example diagram of a possible structure of another power amplifier apparatus 1 according to an embodiment of this application. FIG. 11 may be considered as an extended embodiment of FIG. 10. As shown in FIG. 11, the power amplifier apparatus 1 may include a control unit 14 connected to a second switch 12.

In a possible implementation, the control unit 14 is configured to: when power of the power amplifier apparatus is less than a first power value, control an output port of a first power amplifier unit 2 to be connected to a first port 41 by using the second switch. The control unit 14 is further configured to: when the power of the power amplifier apparatus is not less than the first power value, control the output port of the first power amplifier unit 2 to be connected to an input port of a second power amplifier unit 3 by using the second switch.

When the power amplifier apparatus 1 works at low power, the second switch 12 is switched to the first port 41, and the second power amplifier unit 3 is in a disabled state. In this case, a radio frequency signal is directly amplified under drive of the first power amplifier unit 2, enters the circulator unit 4, and is output through a third port 43. When the power amplifier apparatus 1 works at high power, the second switch 12 is switched from the first port 41 to the second power amplifier unit 3. In this case, a radio frequency signal is directly amplified by drive of the first power amplifier unit 2, is further amplified by drive of the second power amplifier unit 3, enters the circulator unit 4, and is output through the third port 43, so that a back-off amount of the power amplifier apparatus 1 can be increased, and back-off efficiency is improved.

It should be understood that the control unit 14 may be a processor or a processing circuit. The processor may be a chip. For example, the processor may be a field programmable gate array (field programmable gate array, FPGA), an application-specific integrated circuit (application-specific integrated circuit, ASIC), a system-on-chip (system-on-chip, SoC), a central processing unit (central processing unit, CPU), a network processor (network processor, NP), a digital signal processing circuit (digital signal processor, DSP), a micro controller unit (micro controller unit, MCU), a programmable logic device (programmable logic device, PLD), or another integrated chip.

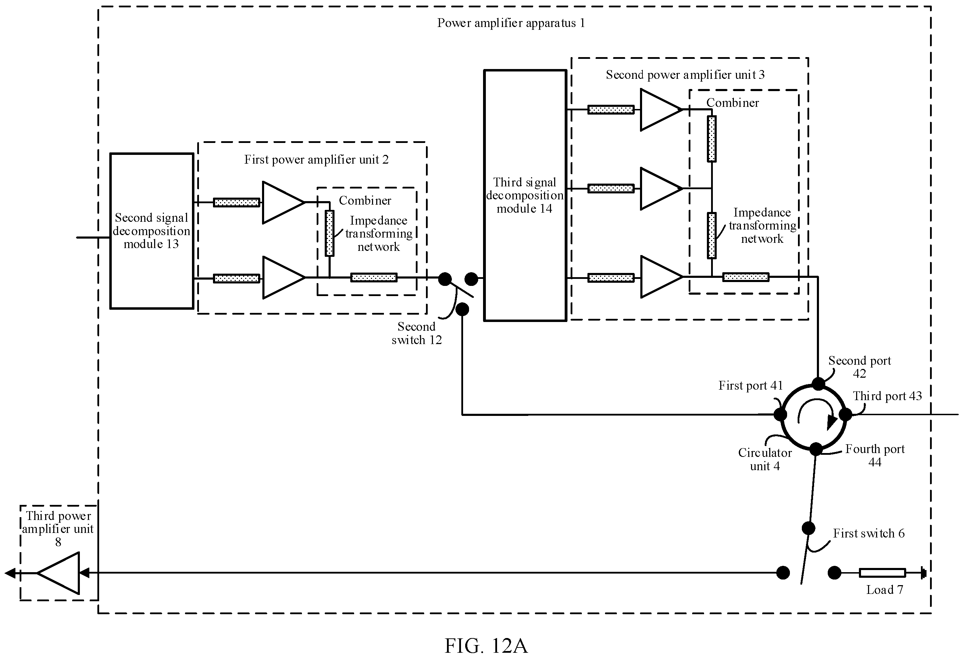

The embodiment shown in FIG. 10 or FIG. 11 may be used in combination with any one or more of the foregoing embodiments in FIG. 2A, FIG. 7A, FIG. 7B, FIG. 7C, FIG. 8A, FIG. 8B, and FIG. 8C. For example, any power amplifier unit in the power amplifier apparatus 1 in FIG. 10 or FIG. 11 may be the power amplifier unit in any one of FIG. 7A, FIG. 7B, or FIG. 7C, and the circulator unit 4 in FIG. 10 or FIG. 11 may be the circulator unit 4 in any one of FIG. 8A, FIG. 8B, and FIG. 8C. Based on FIG. 1, FIG. 2A, FIG. 7A, FIG. 7B, FIG. 7C, FIG. 10, FIG. 11, and the foregoing other content, **FIG. 12A** is an example diagram of a structure of another possible power amplifier apparatus 1 according to an embodiment of this application. FIG. 12A shows an example of a combination of the embodiment shown in FIG. 10 and foregoing embodiment shown in FIG. 7A, FIG. 7B, or FIG. 7C.

In comparison with FIG. 10, a difference in FIG. 12A lies in that a first power amplifier unit 2 uses the architecture of the power amplifier unit shown in FIG. 7A, and a second power amplifier unit 3 uses the architecture of the power amplifier unit shown in FIG. 7B.

As shown in FIG. 12A, the power amplifier apparatus 1 includes a second signal decomposition module 13. An output port of the second signal decomposition module 13 is connected to an input port of the first power amplifier unit 2. The second signal decomposition module 13 is configured to divide a received radio frequency signal into K1 channels of signals, and input the signals in the K1 channels of signals into input ports of K1 power amplifier subunits of the first power amplifier unit 2. K1 is an integer greater than 1. In FIG. 12A, an example in which a value of K1 is 2 is used for illustration.

The power amplifier apparatus 1 includes a third signal decomposition module 14. An output port of the first power amplifier unit 2 is selectively connected to a first port 41 or an input port of the third signal decomposition module 14 by using a second switch. An output port of the third signal decomposition module 14 is connected to an input port of the second power amplifier unit 3.

In a possible implementation, the third signal decomposition module 14 is configured to divide a received radio frequency signal into K2 channels of signals, and input the signals in the K2 channels of signals into input ports of K2 power amplifier subunits of the second power amplifier unit 3. K2 is an integer greater than 1. In FIG. 12A, an example in which a value of K2 is 3 is used for illustration. An output port of the second power amplifier unit 3 is connected to a second port 42.

It can be learned that any power amplifier unit in the solution shown in FIG. 12A may be any power amplifier unit that is more efficient in FIG. 7A, FIG. 7B, or FIG. 7C. In this case, a back-off amount of the power amplifier apparatus 1 can be further increased, and back-off efficiency can be improved.

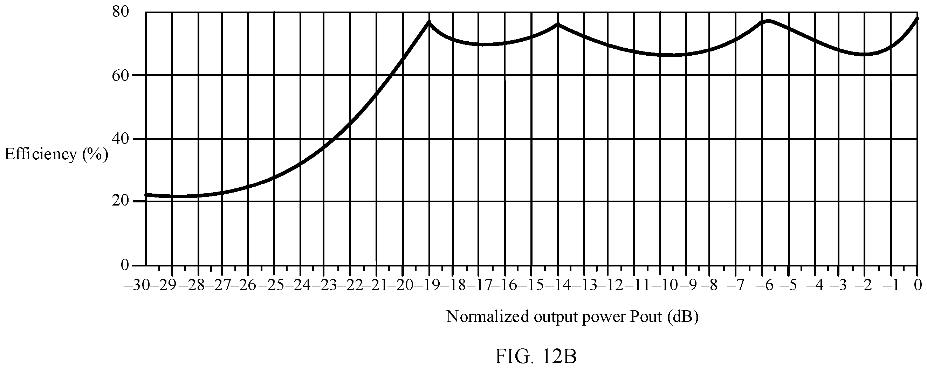

**FIG. 12B** is an example diagram of a possible efficiency curve of the power amplifier apparatus 1 in FIG. 12A. It can be learned from FIG. 12B that, based on a setting of the second switch and a high-efficiency power amplifier architecture nested in the first power amplifier unit and the second power amplifier unit, the back-off amount of the power amplifier apparatus may be further increased, the back-off efficiency may also be improved, and a large quantity of peak points may be added in a medium-power region, to alleviate an "efficiency dip" problem.

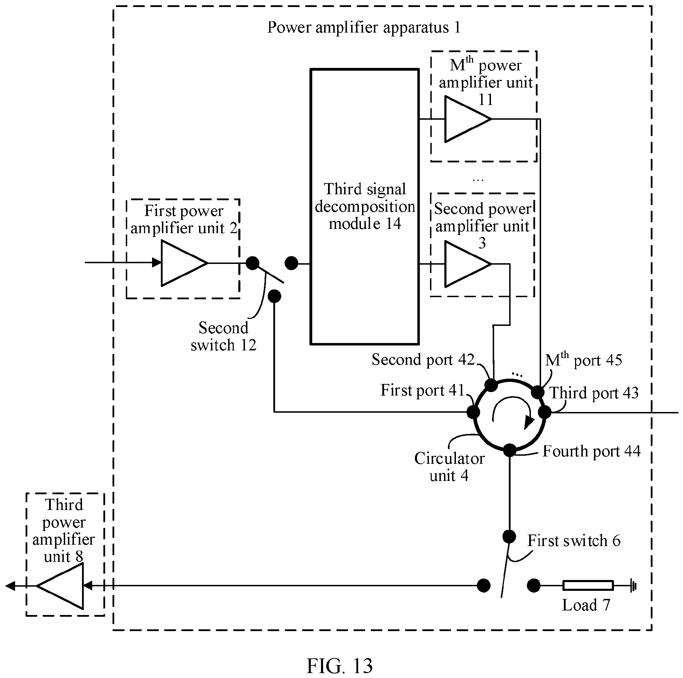

Based on FIG. 1, FIG. 2A, FIG. 7A, FIG. 7B, FIG. 7C, FIG. 10, FIG. 11, FIG. 12A, FIG. 12B, and the foregoing other content, **FIG. 13** is an example diagram of a structure of another possible power amplifier apparatus 1 according to an embodiment of this application. FIG. 13 may be considered as an extended embodiment of FIG. 10. In FIG. 10, an example in which the M power amplifier units include the first power amplifier unit and the second power amplifier unit is used for illustration. In comparison with FIG. 10, FIG. 13 shows an example of a structure in which a power amplifier apparatus 1 includes M power amplifier units.

As shown in FIG. 13, the power amplifier apparatus may include a third signal decomposition module 14. An output port of a first power amplifier unit 2 is selectively connected to a first port 41 or an input port of the third signal decomposition module 14 by using a second switch. An output port of the third signal decomposition module 14 is connected to input ports of (M-1) power amplifier units other than the first power amplifier unit 2 in the M power amplifier units. A circulator unit 4 further includes M ports connected to the M power amplifier units. (M-1) ports other than the first port in the M ports of the circulator unit 4 are respectively connected to output ports of the (M-1) power amplifier units other than the first power amplifier unit 2 in the M power amplifier units. When a signal is received through a port in the M ports, the circulator unit 4 may transmit the signal of the port along a signal transmission direction of the circulator unit 4, and output the signal through a third port. The circulator unit may further implement a function of outputting, through a fourth port, a signal received through the third port from an antenna.

The embodiment shown in FIG. 13 may be used in combination with the foregoing content. For example, any power amplifier unit in FIG. 13 may include one or more power amplifiers. For example, any power amplifier unit in the power amplifier apparatus 1 in FIG. 13 may be the power amplifier unit in any one of FIG. 7A, FIG. 7B, or FIG. 7C. For another example, the circulator unit 4 in FIG. 13 may include one or more circulators. For example, the circulator unit 4 in FIG. 13 may be the circulator unit in any one of FIG. 8A, FIG. 8B, or FIG. 8C.

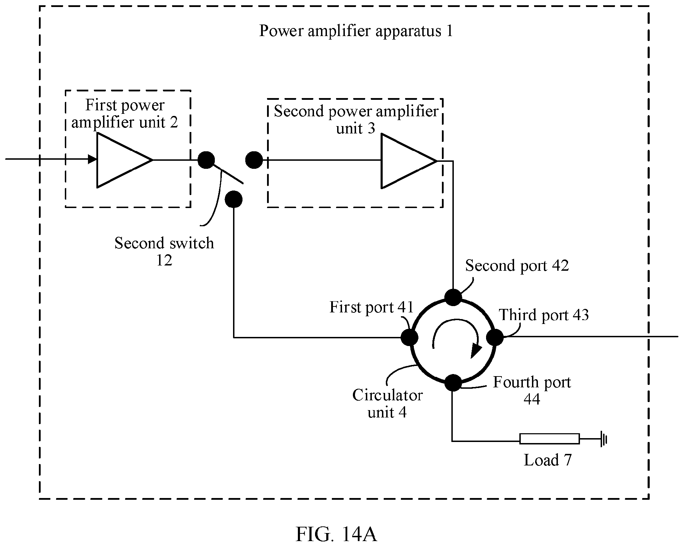

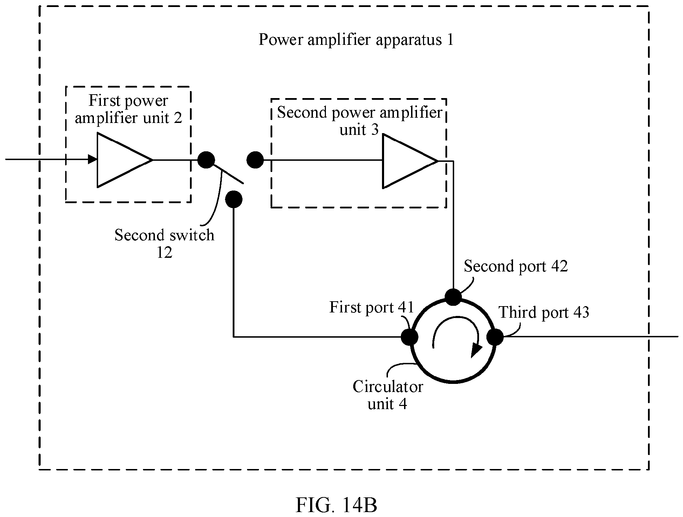

Based on FIG. 1, FIG. 2A, FIG. 7A, FIG. 7B, FIG. 7C, FIG. 10, FIG. 11, FIG. 12A, FIG. 12B, FIG. 13, and the foregoing other content, **FIG. 14A** **and** **FIG. 14B** are example diagrams of several other possible structures of a power amplifier apparatus 1 according to embodiments of this application. The power amplifier apparatus 1 shown in FIG. 14A and FIG. 14B may be the power amplifier apparatus 1 shown in FIG. 2B. It can be learned from FIG. 2B that the power amplifier apparatus 1 provided in embodiments of this application may not need to have a function of implementing switching between a radio frequency transmit channel and a radio frequency receive channel. Therefore, in comparison with FIG. 10, a fourth port 44 of a circulator unit 4 in FIG. 14A may be directly connected to a load 7, and a first switch 6 does not need to be disposed in the power amplifier apparatus 1. In comparison with FIG. 3A, a circulator unit 4 in FIG. 14B may not include a fourth port 44, and the power amplifier apparatus does not need to include a first switch 6 or a load 7 connected to the fourth port 44. For other related content in **FIG. 14A** and **FIG. 14B****,** refer to related descriptions in FIG. 10. Details are not described again.

According to the foregoing content, an embodiment of this application provides a remote radio unit (remote radio unit, RRU). The RRU may include the power amplifier apparatus in any one of embodiments shown in FIG. 3A, FIG. 3B, FIG. 3C, FIG. 5A, FIG. 6A, FIG. 7A, FIG. 7B, FIG. 7C, FIG. 7D, FIG. 8A, FIG. 8B, FIG. 8C, FIG. 9A, FIG. 9B, FIG. 9C, FIG. 10, FIG. 11, FIG. 12A, FIG. 13, FIG. 14A, and FIG. 14B.

According to the foregoing content, an embodiment of this application provides a base station, including the power amplifier apparatus in any one of embodiments shown in FIG. 3A, FIG. 3B, FIG. 3C, FIG. 5A, FIG. 6A, FIG. 7A, FIG. 7B, FIG. 7C, FIG. 7D, FIG. 8A, FIG. 8B, FIG. 8C, FIG. 9A, FIG. 9B, FIG. 9C, FIG. 10, FIG. 11, FIG. 12A, FIG. 13, FIG. 14A, and FIG. 14B.

According to the foregoing content, an embodiment of this application provides a communication system, including a baseband processing unit, at least one power amplifier apparatus in any one of embodiments shown in FIG. 3A, FIG. 3B, FIG. 3C, FIG. 5A, FIG. 6A, FIG. 7A, FIG. 7B, FIG. 7C, FIG. 7D, FIG. 8A, FIG. 8B, FIG. 8C, FIG. 9A, FIG. 9B, FIG. 9C, FIG. 10, FIG. 11, FIG. 12A, FIG. 13, FIG. 14A, and FIG. 14B connected to the baseband processing unit, and an antenna connected to the third port of the circulator unit in the power amplifier apparatus.

It should be noted that a connection in this application describes a connection relationship between two objects, and may represent two connection relationships. For example, a connection between A and B may represent two cases: A is directly connected to B, and A is connected to B through C. In addition, it should be understood that in descriptions of this application, terms such as "first" and "second" are merely used for distinguishing and description, but should not be understood as indicating or implying relative importance, or should not be understood as indicating or implying a sequence. In addition, the system structure and the service scenario provided in embodiments of this application are mainly intended to explain some possible implementations of the technical solutions of this application, and should not be construed as a unique limitation on the technical solutions of this application. A person of ordinary skill in the art may know that, with evolution of a system and emergence of an updated service scenario, the technical solutions provided in this application are also applicable to a same or similar technical problem.

It is clear that a person skilled in the art can make various modifications and variations to this application without departing from the protection scope of this application. In this way, this application is intended to cover these modifications and variations of this application provided that they fall within the scope of protection defined by the following claims and their equivalent technologies.

## Claims

1. A power amplifier apparatus, comprising M power amplifier units and a circulator unit connected to the M power amplifier units, wherein M is an integer greater than 1;
the M power amplifier units comprise a first power amplifier unit and a second power amplifier unit;
an output port of the first power amplifier unit is connected to a first port of the circulator unit;
an output port of the second power amplifier unit is connected to a second port of the circulator unit;
the circulator unit further comprises a third port and a fourth port, and the fourth port is selectively connected to a load or a third power amplifier unit by using a first switch; and
when the fourth port is connected to the load by using the first switch, the circulator unit is configured to output, through the second port and the third port, a signal received through the first port, and output, through the third port, a signal received through the second port; or
when the fourth port is connected to the third power amplifier unit by using the first switch, the circulator unit is configured to output, to the third power amplifier unit through the fourth port, a signal received through the third port.

2. The power amplifier apparatus according to claim 1, wherein the third port of the circulator unit is connected to an antenna.

3. The power amplifier apparatus according to claim 1 or 2, wherein the first power amplifier unit is a main power amplifier unit, and the second power amplifier unit is an auxiliary power amplifier unit; or
the first power amplifier unit is an auxiliary power amplifier unit, and the second power amplifier unit is a main power amplifier unit.

4. The power amplifier apparatus according to any one of claims 1 to 3, further comprising a first signal decomposition module, wherein
an output port of the first signal decomposition module is separately connected to an input port of the first power amplifier unit and an input port of the second power amplifier unit; and
the first signal decomposition module is configured to obtain at least two paths of signals based on a received radio frequency signal, and respectively input the signals in the at least two paths of signals into the first power amplifier unit and the second power amplifier unit.

5. The power amplifier apparatus according to claim 4, wherein the first signal decomposition module is configured to control amplitudes and/or phases of the two paths of signals input into the first power amplifier unit and the second power amplifier unit.

6. The power amplifier apparatus according to claim 5, wherein the first power amplifier unit is a main power amplifier unit, and the second power amplifier unit is an auxiliary power amplifier unit; and
the first signal decomposition module is specifically configured to:
after the second power amplifier unit is enabled,
control a value of a current of the signal input into the second power amplifier unit to increase as output power of the power amplifier apparatus increases, and
control a value of a current of the signal input into the first power amplifier unit to decrease as the output power of the power amplifier apparatus increases; and when the value of the current of the signal input into the first power amplifier unit is less than a preset first current value, control a phase of the current of the signal input into the first power amplifier unit to rotate by 180 degrees, and control the value of the current of the signal input into the first power amplifier unit to increase as the output power of the power amplifier apparatus increases.

7. The power amplifier apparatus according to any one of claims 1 to 6, wherein the first power amplifier unit comprises N1 power amplifier subunits and a first combiner, and N1 is an integer greater than 1; and
output ports of the N1 power amplifier subunits are connected to an input port of the first combiner, and an output port of the first combiner is connected to the first port of the circulator unit.

8. The power amplifier apparatus according to any one of claims 1 to 7, wherein the second power amplifier unit comprises N2 power amplifier subunits and a second combiner, and N2 is an integer greater than 1; and
output ports of the N2 power amplifier subunits are connected to an input port of the second combiner, and an output port of the second combiner is connected to the second port of the circulator unit.

9. The power amplifier apparatus according to claim 8, wherein a power ratio of the first power amplifier unit and the N2 power amplifier subunits is determined based on a back-off amount corresponding to a set efficiency peak point of the power amplifier apparatus.

10. The power amplifier apparatus according to claim 8 or 9, wherein N2 is 2.

11. The power amplifier apparatus according to any one of claims 1 to 10, wherein the circulator unit comprises a first circulator, and the first circulator comprises M ports connected to the M power amplifier units, the third port, and the fourth port; or
the circulator unit comprises a plurality of circulators, and M ports connected to the M power amplifier units, the third port, and the fourth port are deployed in the plurality of circulators.

12. A power amplifier apparatus, comprising M power amplifier units and a circulator unit connected to the M power amplifier units, wherein M is an integer greater than 1;
the M power amplifier units comprise a first power amplifier unit and a second power amplifier unit;
an output port of the first power amplifier unit is selectively connected to a first port of the circulator unit or an input port of the second power amplifier unit by using a second switch;
an output port of the second power amplifier unit is connected to a second port of the circulator unit;
the circulator unit further comprises a third port;
the circulator unit is configured to: when a signal is received through the first port, output, through the second port and the third port, the signal received through the first port; and when a signal is received through the second port, output, through the third port, the signal received through the second port;
the circulator unit further comprises a fourth port, and the fourth port is selectively connected to a load or a third power amplifier unit by using a first switch; and
when the fourth port is connected to the load by using the first switch, the circulator unit is configured to: when a signal is received through the first port, output, through the second port and the third port, the signal received through the first port; and when the signal is received through the second port, output, through the third port, the signal received through the second port; or
when the fourth port is connected to the third power amplifier unit by using the first switch, the circulator unit is configured to output, to the third power amplifier unit through the fourth port, a signal received through the third port.

13. The power amplifier apparatus according to claim 12, further comprising a control unit, wherein
the control unit is connected to the second switch; and
the control unit is configured to: when power of the power amplifier apparatus is less than a first power value, control the output port of the first power amplifier unit to be connected to the first port by using the second switch.

14. The power amplifier apparatus according to claim 12 or 13, wherein the control unit is further configured to: when the power of the power amplifier apparatus is not less than the first power value, control the output port of the first power amplifier unit to be connected to the input port of the second power amplifier unit by using the second switch.

15. The power amplifier apparatus according to any one of claims 12 to 14, wherein the power amplifier apparatus further comprises a second signal decomposition module; and
an output port of the second signal decomposition module is connected to an input port of the first power amplifier unit, the second signal decomposition module is configured to divide a received radio frequency signal into K1 channels of signals, and input the signals in the K1 channels of signals into input ports of K1 power amplifier subunits of the first power amplifier unit, and K1 is an integer greater than 1.

16. The power amplifier apparatus according to any one of claims 12 to 15, wherein the power amplifier apparatus further comprises a third signal decomposition module;
the output port of the first power amplifier unit is selectively connected to the first port or an input port of the third signal decomposition module by using the second switch; and
an output port of the third signal decomposition module is connected to the input port of the second power amplifier unit.

17. The power amplifier apparatus according to claim 16, wherein M is an integer greater than 2, and the M power amplifier units further comprise (M-2) power amplifier units other than the first power amplifier unit and the second power amplifier unit;
the output port of the third signal decomposition module is further connected to input ports of the (M-2) power amplifier units; and
the circulator unit further comprises (M-2) ports connected to the (M-2) power amplifier units.

18. A remote radio unit RRU, comprising the power amplifier apparatus according to any one of claims 1 to 11, or comprising the power amplifier apparatus according to any one of claims 12 to 17.

19. A base station, comprising the power amplifier apparatus according to any one of claims 1 to 11, or comprising the power amplifier apparatus according to any one of claims 12 to 17.

20. A communication system, comprising:
a baseband processing unit;
at least one power amplifier apparatus according to any one of claims 1 to 11 connected to the baseband processing unit, or at least one power amplifier apparatus according to any one of claims 12 to 17 connected to the baseband processing unit; and
an antenna connected to the third port of the circulator unit in the power amplifier apparatus.
